(19) Europäisches Patentamt
European Patent Office
Office européen des brevets

(11) EP 3 270 176 A1

(12) EUROPEAN PATENT APPLICATION

(43) Date of publication:
**17.01.2018 Bulletin 2018/03**

(51) Int Cl.:
***G01R 33/00*** *(2006.01)* ***G01D 5/14*** *(2006.01)*

(21) Application number: **17179368.0**

(22) Date of filing: **03.07.2017**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **14.07.2016 JP 2016139596**

(71) Applicant: **Ricoh Company, Ltd.**
**Tokyo 143-8555 (JP)**

(72) Inventors:
- **WATANABE, Yusuke**
**Tokyo, 143-8555 (JP)**
- **MIKAWA, Akihisa**
**Tokyo, 143-8555 (JP)**

(74) Representative: **J A Kemp**
**14 South Square**
**Gray's Inn**
**London WC1R 5JJ (GB)**

# (54) POSITION DETECTION SYSTEM, POSITION DETECTION METHOD, IMAGE GENERATION UNIT, AND IMAGE PROJECTION APPARATUS

(57) A position detection system (PS) for detecting a position of a movable member includes a magnetic field generation unit (PSF1, 541) to generate a magnetic field (M), a magnetic field detection unit (PSF2, 542) to detect a magnetic flux density (B) of the magnetic field (M) effecting the magnetic field detection unit (PSF2, 542) from the magnetic field generation unit (PSF1, 541), the magnetic flux density (B) of the magnetic field (M) effecting the magnetic field detection unit (PSF2, 542) changeable depending on a change of a position of the magnetic field detection unit (PSF2, 542) relative to a position of the magnetic field generation unit (PSF1, 541), and to output a detection voltage ($V_H$) corresponding to the detected magnetic flux density (B) of the magnetic field (M), the magnetic field detection unit (PSF2, 542) disposed on the movable member, and at least one processor (101) to generate a corrected voltage (Vcor) based on the detection voltage ($V_H$) output from the magnetic field detection unit (PSF2, 542), perform an analog-digital (AD) conversion to the corrected voltage (Vcor) to generate a digital value, set an offset value (OF) used for specifying a characteristic relationship of the corrected voltage (Vcor) and the digital value, calculate a displacement of the magnetic field detection unit (PSF2, 542) relative to the magnetic field generation unit (PSF1, 541) by applying the specified characteristic relationship to the digital value, and detect the position of the movable member based on the calculated displacement of the magnetic field detection unit (PSF2, 542).



Printed by Jouve, 75001 PARIS (FR)

**Description**

BACKGROUND

Technical Field

This disclosure relates to a position detection system, a position detection method, an image generation unit, and an image projection apparatus.

Background Art

A method of detecting a position of a movable member by using a magnetic field generating member such as a Hall element known as a Hall sensor is available.

For example, a method of obtaining an output having linearity in a wide range is disclosed, for example, in JP-2006-292396-A. Specifically, a magnetic field generating member is attached to a movable member, and a change of a magnetic field caused by the movement of the movable member is detected by a magnetic field detecting element. Then, the magnetic field detecting element outputs two detection signals indicating the change of the magnetic field effecting the movable member. Then, a position detector processes the two detection signals to detect a position of the magnetic field generating member, with which the position of the movable member is detected.

However, a detection range of the position of the movable member is relatively narrow for conventional position detection devices.

SUMMARY

In one aspect of the present invention, a position detection system for detecting a position of a movable member is devised. The position detection system includes a magnetic field generation unit to generate a magnetic field, a magnetic field detection unit to detect a magnetic flux density of the magnetic field effecting the magnetic field detection unit from the magnetic field generation unit, the magnetic flux density of the magnetic field effecting the magnetic field detection unit changeable depending on a change of a position of the magnetic field detection unit relative to a position of the magnetic field generation unit, and to output a detection voltage corresponding to the detected magnetic flux density of the magnetic field, the magnetic field detection unit disposed on the movable member; and circuitry to generate a corrected voltage based on the detection voltage output from the magnetic field detection unit, perform an analog-digital conversion to the corrected voltage to generate a digital value, set an offset value used for specifying a characteristic relationship of the corrected voltage and the digital value, calculate a displacement of the magnetic field detection unit relative to the magnetic field generation unit by applying the specified characteristic relationship to the digital value, and detect the position of the movable member based on the calculated displacement of the magnetic field detection unit.

In another aspect of the present invention, a method of detecting a position of a movable member is devised. The method includes generating a magnetic field by using a magnetic field generation unit, detecting a magnetic flux density of the magnetic field generated by the magnetic field generation unit by using a magnetic field detection unit, the magnetic flux density of the magnetic field effecting the magnetic field detection unit changeable depending on a change of a position of the magnetic field detection unit relative to a position of the magnetic field generation unit, the magnetic field detection unit disposed on the movable member, outputting a detection voltage corresponding to the detected magnetic flux density of the magnetic field from the magnetic field detection unit, generating a corrected voltage based on the detection voltage output from the magnetic field detection unit, performing an analog-digital conversion to the corrected voltage to generate a digital value, setting an offset value used for specifying a characteristic relationship of the corrected voltage and the digital value, calculating a displacement of the magnetic field detection unit relative to the magnetic field generation unit by applying the specified characteristic relationship to the digital value, and detecting the position of the movable member based on the calculated displacement of the magnetic field detection unit.

According to the above described aspects of the present invention, the position detection system capable of detecting a position of a movable member in a wider range with an enhance precision can be provided.

BRIEF DESCRIPTION OF THE DRAWINGS

A more complete appreciation of the description and many of the attendant advantages and features thereof can be readily obtained and understood from the following detailed description with reference to the accompanying drawings, wherein:

FIG. 1 is a schematic view of a projector according to an embodiment of the present disclosure.

FIG. 2A is a hardware block diagram of the projector of the embodiment;
FIG. 2B is a hardware block diagram of a system control unit of FIG. 2A;
FIG. 3 is a perspective view of an optical engine of the embodiment;
FIG. 4 is a schematic view of an internal configuration of a light guide unit of the embodiment;
FIG. 5 is a schematic view of an internal configuration of the projection unit of the embodiment;
FIG. 6 is a perspective view of an image generation unit of the embodiment;
FIG. 7 is a side view of the image generation unit of FIG. 6;
FIG. 8 is an exploded perspective view of a fixed unit of the embodiment;
FIG. 9 illustrates a schematic view of a support structure of a movable plate using the fixed unit of FIG. 8;
FIG. 10 is a perspective view of a movable unit of the embodiment;
FIG. 11 is a side view of the movable unit of the embodiment;
FIG. 12 is an exploded perspective view of a configuration including a drive unit of the embodiment;
FIG. 13 is an exploded perspective view of a configuration including a position detection system of the embodiment;
FIG. 14 is an exploded side view of the configuration including the position detection system of the embodiment;
FIG. 15 is a schematic configuration of the position detection system of the embodiment;
FIG. 16 is a schematic view illustrating a Hall Voltage of the embodiment;
FIG. 17 illustrates an example of a characteristic relationship of displacement and Hall voltage of the embodiment with illustrations of (A), (B), (C) and (D);
FIG. 18 is a flow chart illustrating the steps of a first example process of detecting a position of the movable unit of the embodiment;
FIG. 19 schematically illustrates example profiles indicating an effect of a gain value;
FIG. 20 schematically illustrates example profiles indicating an effect of an offset value;
FIG. 21 is a flow chart illustrating a second example process of detecting a position of the embodiment;
FIG. 22 illustrates an example of an arrangement of position-detection magnets of the embodiment;
FIG. 23 illustrates an example of a plurality of detection ranges of the embodiment, which can be changed one to another;
FIG. 24 is a flow chart illustrating the steps of a third example process of detecting a position of the embodiment;
FIG. 25A illustrates another example of a plurality of detection ranges of the embodiment, which can be changed one to another; and
FIG. 25B illustrates an example of changing an offset value to shift a detection range of a table;
FIG. 26 is a functional block diagram of the position detection system of the embodiment.

The accompanying drawings are intended to depict exemplary embodiments of the present invention and should not be interpreted to limit the scope thereof. The accompanying drawings are not to be considered as drawn to scale unless explicitly noted, and identical or similar reference numerals designate identical or similar components throughout the several views.

## DETAILED DESCRIPTION

A description is now given of exemplary embodiments of present disclosure. It should be noted that although such terms as first, second, etc. may be used herein to describe various elements, components, regions, layers and/or sections, it should be understood that such elements, components, regions, layers and/or sections are not limited thereby because such terms are relative, that is, used only to distinguish one element, component, region, layer or section from another region, layer or section. Thus, for example, a first element, component, region, layer or section discussed below could be termed a second element, component, region, layer or section without departing from the teachings of present disclosure.

In addition, it should be noted that the terminology used herein is for the purpose of describing particular embodiments only and is not intended to be limiting of present disclosure. Thus, for example, as used herein, the singular forms "a", "an" and "the" are intended to include the plural forms as well, unless the context clearly indicates otherwise. Moreover, the terms "includes" and/or "including", when used in this specification, specify the presence of stated features, integers, steps, operations, elements, and/or components, but do not preclude the presence or addition of one or more other features, integers, steps, operations, elements, components, and/or groups thereof. Furthermore, although in describing views illustrated in the drawings, specific terminology is employed for the sake of clarity, the present disclosure is not limited to the specific terminology so selected and it is to be understood that each specific element includes all technical equivalents that operate in a similar manner and achieve a similar result. Referring now to the drawings, one or more apparatuses or systems according to one or more embodiments are described hereinafter.

Hereinafter, a description is given of one or more embodiments of the present disclosure with reference to drawings. In this disclosure, components having the same or similar functional configuration among the embodiments of the present disclosure are assigned with the same references, and described by omitting the descriptions if redundant.

As disclosed in the following disclosure, a position detection system of the present disclosure can be applied to an image projection apparatus. Hereinafter, a description is given of the position detection system of the present disclosure applied to the image projection apparatus. It should be noted that the position detection system of the present disclosure can be applied to other apparatuses.

(First embodiment)

(Image Projection Apparatus)

FIG. 1 is a schematic view of a projector 1 according to an embodiment of the present disclosure.

In this disclosure, the projector 1 is used an example of image projection apparatuses. As illustrated in FIG. 1, the projector 1 includes, for example, an emission window 3 and an external interface (I/F) 9, and an optical engine for generating a projection image in a casing of the projector 1. As to the projector 1, for example, when image data is transmitted from other devises such as a personal computer and a digital camera connected to the external I/F 9, the optical engine generates a projection image based on the received image data and projects an image P from the emission window 3 to a screen S as illustrated in FIG. 1. The other devises such as the personal computer and the digital camera can be connected to the external I/F 9 wirelessly or by wire

In the following drawings, an X1-X2 direction indicates a width direction of the projector 1, a Y1-Y2 direction indicates a depth direction of the projector 1, and a Z1-Z2 direction indicates a height direction of the projector 1. Further, a side where the emission window 3 of the projector 1 is provided may be described as a upper side of the projector 1, and a side opposite to the emission window 3 may be described as a lower side of the projector 1 in the Z1-Z2 direction.

FIG. 2A is a hardware block diagram of the projector 1 of the embodiment.

As illustrated in FIG. 2A, the projector 1 includes, for example, a power supply 4, a main switch SW5, an operating unit 7, an external I/F 9, a system control unit 10, an optical engine 15, and a fan 20.

The power supply 4 is connected to a commercial power supply, converts a voltage and a frequency of the commercial power supply to a voltage and a frequency for an internal circuit of the projector 1, and supplies power to the system control unit 10, the optical engine 15, the fan 20, and so on.

The main switch SW5 is used by a user to perform an ON/OFF operation of the projector 1. When the main switch SW5 is turned on when the power supply 4 is connected to the commercial power supply through a power cord, the power supply 4 starts to supply power to each of the units of the projector 1, and when the main switch SW5 is turned off, the power supply 4 stops the supply of power to each of the units of the projector 1.

The operating unit 7 includes a button and the like that receives various operations performed by a user, and is disposed on, for example, the top face of the projector 1. The operating unit 7 receives user operations such as a size, a color tone, and a focus adjustment of a projection image. The user operation received by the operating unit 7 is transmitted to the system control unit 10.

The external I/F 9 has a connection terminal connectable to a device such as a personal computer or a digital camera, and outputs image data transmitted from the connected device to the system control unit 10.

FIG. 2B is a hardware block diagram of the system control unit 10 of FIG. 2A. The system control unit 10 includes, for example, an image control unit 11, and a movement control unit 12. As illustrated in FIG. 2B, the system control unit 10 includes, for example, a central processing unit (CPU) 101, a read-only memory (ROM) 105, a random access memory (RAM) 103, and an interface (I/f) 107, and the functions of the units of the system control unit 10 such as the image control unit 11 and the movement control unit 12 are implemented when the CPU 101 executes programs stored in the ROM 105 in cooperation with the RAM 103, but not limited thereto. For example, at least part of the functions of the units of the system control unit 10 (image control unit 11, movement control unit 12) can be implemented by a dedicated hardware circuit (a semiconductor integrated circuit etc.). The program executed by the system control unit 10 according to the present embodiment may be configured to be provided by being recorded in a computer-readable recording medium such as a compact disk read only memory (CD-ROM), a flexible disk (FD), a compact disk recordable (CD-R), a digital versatile disk (DVD), and a universal serial bus (USB) memory as a file of an installable format or of an executable format. Alternatively, the program may be configured to be provided or distributed through a network such as the Internet. Moreover, various programs may be configured to be provided by being pre-installed into a non-volatile memory such as ROM 105.

The image control unit 11 controls a digital micromirror device (DMD) 551 disposed in an image generation unit 50 of the optical engine 15 based on image data input via the external I/F 9 to generate an image to be projected to the screen S.

The movement control unit 12 controls a drive unit that moves a movable unit 55, movably disposed in the image generation unit 50, to control the position of the DMD 551 disposed in the movable unit 55. The drive unit will be described later in this disclosure.

The fan 20 is rotated under a control of the system control unit 10 to cool the light source 30 of the optical engine 15.

As illustrated in FIG. 2A, the optical engine 15 includes, for example, a light source 30, a light guide unit 40, an image generation unit 50, and a projection unit 60, and is controlled by the system control unit 10 to project an image to the screen S.

The light source 30 is, for example, a high-pressure mercury lamp, a Xenon lamp, and a light-emitting diode (LED), and is controlled by the system control unit 10 to emit the light to the DMD 551 disposed in the image generation unit 50 via the light guide unit 40.

The light guide unit 40 includes, for example, a color wheel, a light tunnel, a relay lens and the like, and guides the light emitted from the light source 30 to the DMD 551 disposed in the image generation unit 50.

The image generation unit 50 includes, for example, a fixed unit 51 fixedly supported in the projector 1, and a movable unit 55 movably supported by the fixed unit 51. The movable unit 55 includes, for example, the DMD 551, and a position of the movable unit 55 with respect to the fixed unit 51 is controlled by the movement control unit 12 of the system control unit 10. The DMD 551 is an example of an image generation element or image generator, and the DMD 551 is controlled by the image control unit 11 of the system control unit 10, and the DMD 551 modulates the light emitted from the light source 30 and guided to the DMD 551 via the light guide unit 40 to generate a projection image. In this description, the fixed unit 51 may be also referred to as the non-movable unit or the first unit, and the movable unit 55 may be also referred to as the second unit.

The projection unit 60 includes, for example, a plurality of projection lenses, mirrors and the like, and enlarges an image generated by the DMD 551 of the image generation unit 50 to project an image to the screen S. The projection unit 60 is an example of a projection device.

(Configuration of optical engine)

A description is given of a configuration of each of units of the optical engine 15 in the projector 1.

FIG. 3 is a perspective view of the optical engine 15 of the embodiment. As illustrated in FIG. 3, the optical engine 15 includes, for example, the light source 30, the light guide unit 40, the image generation unit 50, and the projection unit 60, which are disposed inside the projector 1.

The light source 30 is disposed at one side of the light guide unit 40, and emits light in the X2 direction. The light guide unit 40 guides the light emitted from the light source 30 to the image generation unit 50 disposed under the light guide unit 40. The image generation unit 50 uses the light emitted from the light source 30 and guided by the light guide unit 40 to generate a projection image. The projection unit 60 is disposed above the light guide unit 40, and projects the projection image generated by the image generation unit 50 to the outside of the projector 1.

The optical engine 15 of the embodiment is configured to project the image to a upward direction using the light emitted from the light source 30, but not limited thereto. For example, the optical engine 15 can be configured to project the image to a horizontal direction.

(Light guide unit)

FIG. 4 is a schematic view of an internal configuration of the light guide unit 40 of the embodiment.

As illustrated in FIG. 4, the light guide unit 40 includes, for example, a color wheel 401, a light tunnel 402, relay lenses 403 and 404, a flat mirror 405, and a concave mirror 406.

The color wheel 401 is, for example, a disk having filters of R (Red) color, G (Green) color, and B (Blue) color arranged in different portions in the disk such as different portions in a circumferential direction of the disk. The color wheel 401 is configured to rotate with a high speed to divide the light emitted from the light source 30 into the RGB colors with a time division manner.

For example, the light tunnel 402 is formed into a rectangular tube shape by attaching plate glasses. The light tunnel 402 reflects each of R, G, and B color light, coming from the color wheel 401, for a multiple times in the light tunnel 402 to homogenize luminance distribution of the light, and guides the light to the relay lenses 403 and 404.

The relay lenses 403 and 404 condense the light while correcting the axial chromatic aberration of the light exiting from the light tunnel 402.

The flat mirror 405 and the concave mirror 406 reflects the light exiting from the relay lenses 403 and 404 to the DMD 551 disposed in the image generation unit 50. The DMD 551 modulates the light reflected from the concave mirror 406 to generate a projection image.

(Projection unit)

FIG. 5 is a schematic view of an internal configuration of the projection unit 60 of the embodiment.

As illustrated in FIG. 5, the projection unit 60 includes, for example, a projection lens 601, a reflection mirror 602, and a curved mirror 603 disposed inside a casing of the projection unit 60.

The projection lens 601 includes, for example, a plurality of lenses, and forms a projection image generated by the DMD 551 of the image generation unit 50 on the reflection mirror 602. The reflection mirror 602 and the curved mirror 603 reflect the formed projection image by enlarging the projection image, and projects the enlarged projection image to the screen S or the like disposed outside the projector 1.

(Image generation unit)

FIG. 6 is a perspective view of the image generation unit 50 of the embodiment. FIG. 7 is a side view of the image generation unit 50 of the embodiment.

As illustrated in FIG, 6 and FIG. 7, the image generation unit 50 includes the fixed unit 51, and the movable unit 55. The fixed unit 51 is fixed to the light guide unit 40 while the movable unit 55 is moveably supported by the fixed unit 51.

The fixed unit 51 includes a top plate 511 as a first fixed plate, and a base plate 512 as a second fixed plate. In the fixed unit 51, the top plate 511 and the base plate 512 are provided in parallel with each other with a given space therebetween. The fixed unit 51 is fixed to a bottom side of the light guide unit 40 by using four screws 520 illustrated in FIG. 6.

The movable unit 55 includes the DMD 551, a movable plate 552 as a first movable plate, a DMD substrate 553 as a second movable plate, and a heat sink 554 as a heat radiating unit, and the movable unit 55 is movably supported by the fixed unit 51.

The DMD 551 is disposed on a upper face of the DMD substrate 553. The DMD 551 includes an image generation plane where a plurality of movable micromirrors are arranged in a lattice pattern. As to each of the micromirrors of the DMD 551, the mirror surface of each of the micromirrors of the DMD 551 is mounted tiltably about a torsion axis, and each of the micromirrors of the DMD 551 is ON/OFF driven based on an image signal transmitted from the image control unit 11 of the system control unit 10.

For example, in the case of "ON," an inclination angle of the micromirror is controlled so as to reflect the light emitted from the light source 30 to the projection unit 60. Further, for example, in the case of "OFF," an inclination angle of the micromirror is controlled in a direction for reflecting the light emitted from the light source 30 toward the OFF plate.

With this configuration, in the DMD 551, the inclination angle of each of the micromirrors is controlled by the image signal transmitted from the image control unit 11, and the DMD 551 modulates the light emitted from the light source 30 and guided by the light guide unit 40 to generate a projection image.

The movable plate 552 is configured to be supported between the top plate 511 and the base plate 512 of the fixed unit 51, in which the movable plate 552 is movable in a direction parallel to the surfaces of the top plate 511 and the base plate 512.

The DMD substrate 553 is provided between the top plate 511 and the base plate 512 of the fixed unit 51, and is fixed to a lower face of the movable plate 552. The DMD 551 is disposed on the upper face of the DMD substrate 553, and thereby the DMD 551 is movable with the movable plate 552 that is disposed movably as described above.

The heat sink 554 radiates heat generated by the DMD 551, in which at least a part of the heat sink 554 is in contact with the DMD 551, which enables the DMD 551 to be efficiently cooled. The heat sink 554 suppresses an increase of the temperature of the DMD 551 so that occurrence of troubles such as a malfunction or a failure due to the increase of the temperature of the DMD 551 can be reduced. The heat sink 554 is provided movably together with the movable plate 552 and the DMD substrate 553. With this configuration, the heat generated by the DMD 551 can be radiated constantly.

(Fixed Unit)

FIG. 8 is an exploded perspective view of the fixed unit 51 of the embodiment.

As illustrated in FIG. 8, the fixed unit 51 includes the top plate 511 and the base plate 512.

Each of the top plate 511 and the base plate 512 is formed from a plate member such as a flat plate formed of magnetic material such as iron or stainless steel. The top plate 511 and the base plate 512 are provided in parallel with each other by a plurality of supports 515 with a given space therebetween.

The top plate 511 has a central hole 514 provided at a position corresponding to the DMD 551 of the movable unit 55. Further, the base plate 512 has a heat transfer hole 519 formed at a position corresponding to the DMD 551, and a heat transfer unit 563 of the heat sink 554 (FIG. 11) is inserted through the heat transfer hole 519.

As illustrated in FIG. 8, a upper end of the support 515 is inserted into a supporting hole 516 formed in the top plate 511, and a lower end of the support 515 is inserted into a supporting hole 517 formed in the base plate 512. A plurality of the supports 515 forms a given space between the top plate 511 and the base plate 512 and supports the top plate 511 and the base plate 512 in a parallel manner.

As illustrated in FIG. 8, four screw holes 518 are formed around the central hole 514 in the top plate 511. In this example configuration, two of the four screw holes 518 is continuously formed with the central hole 514. The top plate 511 is fixed to the bottom side of the light guide unit 40 by using the four screws 520 (see FIG. 6) respectively inserted in the four screw holes 518.

Further, a plurality of supporting holes 526 is formed in the top plate 511. Each of the supporting holes 526 rotatably holds a supporting sphere 521 that movably supports the movable plate 552 from the upper side of the movable plate 552. Further, a plurality of supporting holes 522 is formed in the base plate 512. Each of the supporting holes 522 rotatably holds a supporting sphere 521 that movably supports the movable plate 552 from the lower side of the movable plate 552.

The upper end of the supporting hole 526 of top plate 511 is covered by a lid member 527, and the supporting hole 526 rotatably holds the supporting sphere 521. Further, a cylindrical holding member 523 having a female screw groove in its inner periphery is inserted into the supporting hole 522 of the base plate 512. The lower end of the cylindrical holding member 523 is covered by a position adjustment screw 524, and the cylindrical holding member 523 rotatably holds the supporting sphere 521.

The supporting spheres 521 rotatably held by the supporting holes 526 and 522 respectively formed in the top plate 511 and the base plate 512 are in contact with the movable plate 552 provided between the top plate 511 and the base plate 512 to movably support the movable plate 552 from the both faces of the movable plate 552.

FIG. 9 illustrates a schematic view of a support structure of the movable plate 552 using the fixed unit 51.

As illustrated in FIG. 9, in the top plate 511, the supporting sphere 521 is rotatably held by the supporting hole 526, and the upper end of the supporting hole 526 is covered by the lid member 527. Further, in the base plate 512, the supporting sphere 521 is rotatably held by the cylindrical holding member 523 inserted into the supporting hole 522.

Each of the supporting spheres 521 is held such that at least a part of the supporting sphere 521 protrudes from the supporting holes 522 and 526, and are in contact with the movable plate 552 provided between the top plate 511 and the base plate 512. The movable plate 552 is supported by the rotatably provided supporting spheres 521 from both sides of the movable plate 552 so as to be supported in parallel to the top plate 511 and the base plate 512 and movably in a direction parallel to the surfaces of the top plate 511 and the base plate 512.

Further, as to the supporting sphere 521 disposed on the base plate 512, an amount of protrusion of the supporting sphere 521 from the upper end of the cylindrical holding member 523 can be changed by adjusting the position of the position adjustment screw 524. For example, when the position adjustment screw 524 is displaced in the Z1 direction, the amount of protrusion of the supporting sphere 521 increases so that an interval between the base plate 512 and the movable plate 552 is increased. Further, for example, when the position adjustment screw 524 is displaced in the Z2 direction, the amount of protrusion of the supporting sphere 521 decreases so that the interval between the base plate 512 and the movable plate 552 is reduced.

With this configuration, by changing the amount of protrusion of the supporting sphere 521 using the position adjustment screw 524, the interval between the base plate 512 and the movable plate 552 can be appropriately adjusted.

Further, as illustrated in FIG. 8, a plurality of position-detection magnets 541 is disposed on the upper face of the base plate 512. Each of the position-detection magnets 541 is configured with two cuboid permanent magnets arranged such that their longitudinal directions are parallel with each other, and the two cuboid permanent magnets form a magnetic field effecting the DMD substrate 553 disposed between the top plate 511 and the base plate 512. Hereinafter, the plurality of position-detection magnets 541 may be simply referred to as the position-detection magnet 541 for the simplicity of the description.

The position-detection magnet 541 and the Hall element 542 (FIG. 11) disposed on the lower face of the DMD substrate 553 can be used as components to configure a position detection system that detects a position of the DMD 551.

Further, as illustrated in FIG. 8, a plurality of drive-use magnet units 531a, 531b, 531c is disposed on the lower face of the base plate 512, wherein the drive-use magnet unit 531c is not seen in FIG. 8. Hereinafter, the plurality of drive-use magnet units 531a, 531b, 531c may be simply referred to as the drive-use magnet unit 531 or the drive-use magnet units 531.

Each of the drive-use magnet units 531 includes two permanent magnets having rectangular parallelepiped shape and arranged in parallel along a long side of the two permanent magnets, and the two permanent magnets form a magnetic field effecting the heat sink 554. A combination of the drive-use magnet unit 531 and a drive coil 581 disposed on the upper face of the heat sink 554 configure a drive unit that moves the movable unit 55.

Further, the number and position of the supports 515 and the supporting spheres 521 provided in the fixed unit 51 are not limited to the configuration illustrated in the embodiment.

(Movable unit)

FIG. 10 is a perspective view of the movable unit 55 of the embodiment. FIG. 11 is a side view of the movable unit 55 of the embodiment.

As illustrated in FIG. 10 and FIG. 11, the movable unit 55 includes, for example, the DMD 551, the movable plate 552, the DMD substrate 553, and the heat sink 554.

As described above, the movable plate 552 is provided between the top plate 511 and the base plate 512 of the fixed unit 51, and is supported movably in a direction parallel to the surfaces of the top plate 511 and the base plate 512 by the supporting spheres 521.

As illustrated in FIG. 10, the movable plate 552 has a central hole 570 formed at a position corresponding to the DMD 551 disposed on the DMD substrate 553, and through holes 572 into which the screws 520 to fix the top plate 511 to the light guide unit 40 are inserted. Further, a plurality of link-use holes 573 is formed in the movable plate 552 used for linking the movable plate 552 to the DMD substrate 553, and a movable range restriction hole 571 is formed in the movable plate 552 at a position corresponding to the support 515 of the fixed unit 51.

The movable plate 552 and the DMD substrate 553 are linked and fixed with each other by screws inserted into the link-use holes 573 in a state that an interval between the movable plate 552 and the DMD substrate 553 is adjusted such that the surface of the movable plate 552 and the image generation plane of the DMD 551 are set in parallel with each other, in which the movable plate 552 and the DMD substrate 553 can be fixed firmly by using an adhesive.

In the above described configuration, the movable plate 552 moves in a direction parallel to the surface of the movable plate 552, and the DMD 551 also moves with the movable plate 552. Therefore, if the surface of the movable plate 552 and the image generation plane of the DMD 551 are not in parallel with each other, the image generation plane of the DMD 551 may be inclined with respect to a moving direction of the DMD 551, with which an image may be distorted (i.e., image quality deteriorates).

Therefore, in the embodiment, the interval between the movable plate 552 and the DMD substrate 553 is adjusted with the screws inserted in the link-use holes 573, and the surface of the movable plate 552 and the image generation plane of the DMD 551 are maintained in parallel with each other, with which deterioration of the image quality can be suppressed.

The support 515 of the fixed unit 51 is inserted in the movable range restriction hole 571, and the movable range restriction hole 571 restricts a movable range of the movable plate 552 by contacting with the support 515 when the movable plate 552 is largely moved due to, for example, vibration or some abnormality.

Further, the number, position, and the shape of the link-use holes 573 and the movable range restriction hole 571 are not limited to the configuration illustrated in the embodiment. Further, the movable plate 552 and the DMD substrate 553 can be connected or linked with each other using a configuration different from the configuration of the embodiment.

The DMD substrate 553 is provided between the top plate 511 and the base plate 512 of the fixed unit 51, and is linked to the lower face of the movable plate 552 as described above.

The DMD 551 is disposed on the upper surface of the DMD substrate 553. The DMD 551 is connected to the DMD substrate 553 via a socket 557 and the periphery of the DMD 551 is covered by a cover 558. The DMD 551 is exposed through the central hole 570 of the top plate 511 to the upper face side of the movable plate 552.

As to the DMD substrate 553, through holes 555 are formed in the DMD substrate 553 through which the screws 520 for fixing the top plate 511 to the light guide unit 40 are inserted. Further, as to the DMD substrate 553, notches 588 are formed at portions facing the link members 561 such that the movable plate 552 is fixed to the link members 561 of the heat sink 554.

For example, if the movable plate 552 and the DMD substrate 553 are both fixed to the link member 561 of the heat sink 554, the DMD substrate 553 may be distorted, and the image generation plane of the DMD 551 may be inclined with respect to the moving direction, in which there is a possibility that an image may be distorted. In view of this issue, the notches 588 are formed at peripheral portions of the DMD substrate 553 so that the link members 561 of the heat sink 554 are linked to the movable plate 552 while avoiding the DMD substrate 553.

With this configuration, since the heat sink 554 is connected and linked to the movable plate 552, a possibility that the DMD substrate 553 receives a load from the heat sink 554 can be reduced, and thereby an image distortion can be reduced. Therefore, the image quality can be maintained by maintaining the image generation plane of the DMD 551 parallel to the moving direction.

Further, the notch 588 is formed for the DMD substrate 553 by setting a size of the notch 588 greater than an area around the supporting holes 522 of the base plate 512 so that the supporting sphere 521 held on the base plate 512 contacts the movable plate 552 while avoiding the DMD substrate 553. With this configuration, the DMD substrate 553 is prevented from being distorted due to the load from the supporting sphere 521, and the image generation plane of the DMD 551 can be moved in parallel to the moving direction, with which the image quality can be maintained.

Further, the shape of the notch 588 is not limited to the shape exemplified in the embodiment. For example, instead of the notch 588, a through hole can be formed in the DMD substrate 553 as long as the DMD substrate 553 is not contact with the link members 561 of the heat sink 554 and the supporting sphere 521.

Further, as illustrated in FIG. 11, a plurality of Hall elements 542 is disposed on the lower face of the DMD substrate 553 at a plurality of positions facing the position-detection magnets 541 disposed on the upper face of the base plate 512, in which the Hall element 542 is used as an example of a magnetic sensor. The Hall element 542 and the position-detection magnet 541 disposed on the base plate 512 can be used as components to configure the position detection system that detects a position of the DMD 551.

As illustrated in FIG. 10 and FIG. 11, the heat sink 554 includes, for example, a heat dissipation unit 556, the link members 561, and the heat transfer unit 563.

As illustrated in FIG. 10, a plurality of fins are formed at the lower part of the heat dissipation unit 556 for radiating heat generated by the DMD 551. As illustrated in FIG. 10, a plurality of concave portions 582 is formed on the upper face of the heat dissipation unit 556 to set the drive coils 581a, 581b, and 581c, attached on a flexible substrate 580, in each of the concave portions 582 respectively. In the following description, the drive coils 581a, 581b, and 581c may be simply referred to as the drive coils 581 or the drive coil 581.

The concave portion 582 is formed at a position facing the drive-use magnet unit 531 disposed on the lower face of the base plate 512. A combination of the drive coil 581 attached to the concave portion 582 of the heat dissipation unit 556 and the drive-use magnet unit 531 disposed on the lower face of the base plate 512 configure the drive unit used for moving the movable unit 55 with respect to the fixed unit 51.

Further, through holes 562 are formed in the heat dissipation unit 556, through which the screws 520 for fixing the top plate 511 to the light guide unit 40 are inserted.

The link members 561 are formed at three portions while extending in the Z1 direction from the upper face of the heat dissipation unit 556, and the movable plate 552 is fixed to the upper end of each of the link members 561 by screws 564 (see FIG. 11). The link members 561 are linked to the movable plate 552 without contacting the DMD substrate 553 because the notches 588 are formed in the DMD substrate 553.

As illustrated in FIG. 11, the heat transfer unit 563 extends in the Z1 direction from the upper face of the heat dissipation unit 556, and abuts against the lower face of the DMD 551, with which heat generated by the DMD 551 is transferred to the heat dissipation unit 556 via the heat transfer unit 563. Further, a heat transfer sheet can be provided between the upper end face of the heat transfer unit 563 and the DMD 551 to increase heat conductivity. By setting the heat transfer sheet, thermal conductivity between the heat transfer unit 563 of the heat sink 554 and the DMD 551 is enhanced, with which the cooling effect of the DMD 551 is enhanced.

As illustrated in FIG. 10, the through hole 572 of the movable plate 552, the through hole 555 of the DMD substrate 553, and the through hole 562 of the heat sink 554 are formed by aligning the through holes 572, 555, and 562 along the Z1-Z2 direction, and the screw 520 for fixing the top plate 511 to the light guide unit 40 is inserted from the bottom side.

In the above described configuration, there is a space between the surface of the DMD substrate 553 and the image generation plane of the DMD 551, in which the space corresponds to the thickness of the socket 557 and the thickness of the DMD 551. If the DMD substrate 553 is placed above the upper side of the top plate 511, the space from the surface of the DMD substrate 553 to the image generation plane of the DMD 551 becomes a dead space, with which the apparatus configuration may become larger.

In the embodiment, by providing the DMD substrate 553 between the top plate 511 and the base plate 512, the top plate 511 is placed in the space from the surface of the DMD substrate 553 to the image generation plane of the DMD 551. With this configuration, the height in the Z1-Z2 direction can be reduced by effectively utilizing the space from the surface of the DMD substrate 553 to the image generation plane of the DMD 551, with which the apparatus configuration can be reduced. Therefore, the image generation unit 50 of the embodiment can be assembled not only to larger projectors but also to smaller projectors, in which versatility of the image generation unit 50 is enhanced.

(Drive unit)

FIG. 12 is an exploded perspective view of a configuration including the drive unit of the embodiment.

In the embodiment, the drive unit includes, for example, the drive-use magnet unit 531 disposed on the base plate 512, and the drive coil 581 disposed on the heat sink 554.

Each of the drive-use magnet unit 531a and the drive-use magnet unit 531b is configured with two permanent magnets, and the longitudinal direction of the two permanent magnets are set parallel to the X1-X2 direction. Further, the drive-use magnet unit 531c is configured with two permanent magnets, and the longitudinal direction of the two permanent magnets are set parallel to the Y1-Y2 direction. Each of the drive-use magnet units 531 respectively forms a magnetic field effecting the heat sink 554.

Each of the drive coils 581 is formed by an electric wire being wound about an axis parallel to the Z1-Z2 direction, and attached in the concave portion 582 formed on the upper face of the heat dissipation unit 556 of the heat sink 554.

The drive-use magnet unit 531 on the base plate 512 and the drive coil 581 on the heat sink 554 are provided at positions so as to face each other in a state that the movable unit 55 is supported by the fixed unit 51. When a current is made to flow in the drive coil 581, a Lorentz force used as a drive force for moving the movable unit 55 is generated for the drive coil 581 by the magnetic field formed by the drive-use magnet unit 531.

When the movable unit 55 receives the Lorentz force generated as the drive force between the drive-use magnet unit 531 and the drive coil 581, the movable unit 55 is linearly or rotationally displaced on the X-Y plane with respect to the fixed unit 51.

In the embodiment, the drive coil 581a and the drive-use magnet unit 531a, and the drive coil 581b and the drive-use magnet unit 531b disposed at the opposite positions in the X1-X2 direction configure a first drive unit. When a current is made to flow in the drive coil 581a and the drive coil 581b, a Lorentz force in the Y1 direction or Y2 direction is generated.

The movable unit 55 is moved in the Y1 direction or the Y2 direction by the Lorentz forces generated by the drive coil 581a and the drive coil 581b. Further, the movable unit 55 is displaced to rotate on the X-Y plane by a Lorentz force generated by the drive coil 581a and a Lorentz force generated by the drive coil 581b, which are generated in the opposite directions.

For example, when a current is made to flow in the drive coil 581a to generate a Lorentz force in the Y1 direction, and a current is made to flow in the drive coil 581b to generate a Lorentz force in the Y2 direction, the movable unit 55 is displaced to rotate into a counterclockwise direction when viewed from the top. Further, when a current is made to flow in the drive coil 581a to generate a Lorentz force in the Y2 direction, and a current is made to flow in the drive coil 581b to generate a Lorentz force in the Y1 direction, the movable unit 55 is displaced to rotate into a clockwise direction when viewed from the top.

Further, in the embodiment, the drive coil 581c and the drive-use magnet unit 531c configure a second drive unit. The drive-use magnet unit 531c is arranged such that the longitudinal direction of the drive-use magnet unit 531c is orthogonal to the longitudinal direction of the drive-use magnet unit 531 a and the drive-use magnet unit 531b. In this configuration, when a current is made to flow in the drive coil 581c, a Lorentz force in the X1 direction or X2 direction is generated, and then the movable unit 55 is moved in the X1 direction or the X2 direction by the Lorentz force generated by the drive coil 581c.

The magnitude and direction of the current to be made to flow in each of the drive coils 581 is controlled by the movement control unit 12 of the system control unit 10. The movement control unit 12 controls a movement direction (linear or rotation direction), a movement amount, and a rotation angle of the movable plate 552 by controlling the magnitude and direction of the current to be made to flow in each of the drive coils 581.

Further, a heat transfer hole 559 is formed in the base plate 512 at a portion facing the DMD 551 provided in the DMD substrate 553, and the heat transfer unit 563 of the heat sink 554 is inserted through the heat transfer hole 559. Further, through holes 560 are formed in the base plate 512, and the screws 520 for fixing the top plate 511 to the light guide unit 40 are inserted through the through holes 560.

As to the movable unit 55 of the embodiment, the weight of the heat sink 554 is set greater than the total weight of the movable plate 552 and the DMD substrate 553. Therefore, the center of gravity position of the movable unit 55 in the Z1-Z2 direction is located near the heat dissipation unit 556 of the heat sink 554.

In this configuration, for example, if the drive coil 581 is disposed on the movable plate 552, and a Lorentz force used as a drive force acts the movable plate 552, the center of gravity position of the movable unit 55 and the drive force generation plane locating the drive coil 581 is separated from each other in the Z1-Z2 direction. This situation similarly occurs when the drive coil 581 is provided in the DMD substrate 553.

In the configuration that the center of gravity position of the movable unit 55 and the drive force generation plane are separated, the center of gravity position is set as a support point in the Z1-Z2 direction, and the drive force generation plane is used as an action point in the Z1-Z2 direction, with which a swing like a pendulum may occur. Since a moment acting the drive force generation plane increases as the interval between the support point and the action point becomes longer, the greater the interval of the center of gravity position of the movable unit 55 and the drive force generation plane in the Z1-Z2 direction, the greater the vibration, and it becomes difficult to control the position of the DMD 551.

Further, if the movable unit 55 shakes like a pendulum, the load acting to the movable plate 552, and the top plate 511 and the base plate 512 supporting the movable plate 552 becomes greater, with which distortion and breakage may occur to each of the plates, and thereby an image may be distorted.

Therefore, in the embodiment, by providing the drive coil 581 in the concave portion 582 of the heat sink 554, as illustrated in FIG. 11, the drive force generation plane is located in the heat dissipation unit 556 of the heat sink 554. With this configuration, the interval between the center of gravity position of the movable unit 55 and the drive force generation plane in the Z1-Z2 direction can be set smaller as much as possible.

Therefore, as to the movable unit 55 of the embodiment, the moving direction of the movable unit 55 can be maintained in a direction parallel to the X-Y plane without swinging like a pendulum so that the above described problems such as distortion and breakage of each plate may not occur, and an operational stability of the movable unit 55 can be enhanced, and the position of the DMD 551 can be controlled with a higher precision. Further, the positions of the drive-use magnet unit 531 a, 531b, 531c and the drive coil 581a, 581b, 581c can be respectively changed, in which the drive-use magnet units 531 are disposed on a side of the heat sink 554 closer to the base plate 512, and the drive coils 581 are disposed on a side of the base plate 512 closer to the heat sink 554, and the same effect of preventing the above described problems such as distortion and breakage of each plate can be devised.

Further, it is preferable that the center of gravity position of the movable unit 55 and the drive force generation plane are matched in the Z1-Z2 direction. For example, by appropriately changing the depth of the concave portion 582 to which the drive coil 581 is attached, and the shape of the heat dissipation unit 556 of the heat sink 554, the center of gravity position of the movable unit 55 and the drive force generation plane can be matched in the Z1-Z2 direction.

(Position detection system)

FIG. 13 is an exploded perspective view of a configuration including the position detection system of the embodiment, and FIG. 14 is an exploded side view of the configuration including the position detection system of FIG. 13.

In the embodiment, the position detection system includes the position-detection magnet 541 disposed on the base plate 512, and the Hall element 542 disposed on the DMD substrate 553. The position-detection magnet 541 and the Hall element 542 are arranged to face with each other in the Z1-Z2 direction.

The Hall element 542 is an example of a magnetic sensor, and the position-detection magnet 541 is provided at a position opposite to the Hall element 542. The Hall element 542 outputs a signal, corresponding to a change of the magnetic flux density effecting from the position-detection magnet 541, to the movement control unit 12 of the system control unit 10. The movement control unit 12 detects a position of the Hall element 542 with respect to the fixed unit 51 based on the signal transmitted from the Hall element 542, and then detects a position of the DMD 551 provided in the DMD substrate 553 based on the detected position of the Hall element 542.

In the embodiment, the top plate 511 and the base plate 512, formed of magnetic material, function as yoke plates and configure a magnetic circuit with the position-detection magnet 541. Further, the magnetic flux generated by the drive unit including the drive-use magnet unit 531 and the drive coil 581, provided between the base plate 512 and the heat sink 554, concentrates on the base plate 512, which functions as the yoke plate, with which the leakage of the magnetic flux from the drive unit to the position detection system is suppressed.

Therefore, at the Hall element 542 disposed on the lower face side of the DMD substrate 553, the influence of the magnetic field formed by the drive unit including the drive-use magnet unit 531 and the drive coil 581 is reduced so that the Hall element 542 can output a signal corresponding to the change of the magnetic flux density of the position-detection magnet 541 without being affected by the magnetic field generated by the drive unit. Therefore, the movement control unit 12 can detect the position of the DMD 551 with higher accuracy.

With this configuration, based on the output of the Hall element 542 with the reduced influence from the drive unit, the movement control unit 12 can detect the position of the DMD 551 with enhanced precision or accuracy. Therefore, the movement control unit 12 can control the magnitude and direction of the current to be made to flow to each of the drive coils 581 depending on the detected position of the DMD 551, and can control the position of the DMD 551 with enhanced precision or accuracy.

Further, the configuration of the drive unit and the position detection system are not limited to the above described configuration exemplified in the embodiment. The number and position of the drive-use magnet unit 531 and the drive coil 581 provided as the drive unit can be set differently from those of the embodiment as long as the movable unit 55 can be moved to any positions within a given range. Further, the number and position of the position-detection magnet 541 and the Hall element 542 used for configuring the position detection system can be set differently from those of the embodiment as long as the position of the DMD 551 can be detected.

For example, the position-detection magnet 541 can be disposed on the top plate 511 while the Hall element 542 can be disposed on the movable plate 552. Further, for example, the position detection system can be provided between the base plate 512 and the heat sink 554, and the drive unit can be provided between the top plate 511 and the base plate 512. In these configurations, it is preferable to provide a yoke plate between the drive unit and the position detection system so that the influence of the magnetic field from the drive unit to the position detection system can be reduced. Further, since the controlling of the position of the movable unit 55 becomes difficult when the weight of the movable unit 55 increases, each of the drive-use magnet unit 531 and the position-detection magnet 541 is preferably disposed on the fixed unit 51 such as the top plate 511 or the base plate 512.

Further, the top plate 511 and the base plate 512 can be partially formed of magnetic material if the leakage of magnetic flux from the drive unit to the position detection system can be reduced. For example, each of the top plate 511 and the base plate 512 can be formed by stacking a plurality of members including a flat plate-like or sheet-like member made of magnetic material. If at least a part of the base plate 512 is formed of magnetic material to function as the yoke plate to prevent leakage of magnetic flux from the drive unit to the position detection system, the top plate 511 can be formed of non-magnetic material.

(Image projection)

As described above, as to the projector 1 of the embodiment, a projection image is generated by the DMD 551 provided in the movable unit 55, and the position of the movable unit 55 is controlled by the movement control unit 12 of the system control unit 10.

For example, the movement control unit 12 controls the position of the movable unit 55 with a given cycle corresponding to a frame rate set for an image projection operation so that the movable unit 55 can move with a faster speed between a plurality of positions distanced with each other less than a distance of an arrangement interval of the plurality of micromirrors of the DMD 551, in which the image control unit 11 transmits an image signal to the DMD 551 corresponding to a position of the movable unit 55 shifted by the movement of the movable unit 55 to generate a projection image.

For example , the movement control unit 12 reciprocally moves the DMD 551 between a first position P1 and a second position P2 distanced with each other less than the distance of the arrangement interval of the plurality of micromirrors of the DMD 551 in the X1-X2 direction and the Y1-Y2 direction with a given cycle. In this configuration, the image control unit 11 controls the DMD 551 to generate a projection image corresponding the position of the movable unit 55 shifted by the movement of the movable unit 55 to generate a projection image, with which the resolution level of the projection image can be set about two times of the resolution level of the DMD 551. Further, the resolution level of the projection image can be set greater than the two times of the resolution level of the DMD 551 by increasing the number of positions used for the movement of the DMD 551.

As above described, when the movement control unit 12 moves or sifts the DMD 551 together with the movable unit 55, the image control unit 11 can generate a projection image corresponding to a sifted position of the DMD 551, with which an image having a resolution level higher than the resolution level of the DMD 551 can be projected.

Further, as to the projector 1 of the above described embodiment, the movement control unit 12 can control the DMD 551 and the movable unit 55 concurrently, which means the movement control unit 12 can rotate the DMD 551 and the movable unit 55 concurrently, with which a projection image can be rotated without reducing a size of the projection image. Conventionally, an image generator (e.g., DMD) is fixed in a projector, in which a size of a projection image is required to be reduced to rotate the projection image while maintaining an aspect ratio of the projection image. By contrast, the DMD 551 can be rotated in the projector 1 of the embodiment. Therefore, a projection image can be rotated without reducing a size of the projection image, and an inclination of the projection image can be adjusted.

As described above, as to the image generation unit 50 of the embodiment, the DMD 551 is provided movably, and an image can be generated with higher resolution by shifting the DMD 551.

Further, in the embodiment, the drive force to move the movable unit 55 acts the heat sink 554, and the interval between the center of gravity position of the movable unit 55 and the drive force generation plane in the Z1-Z2 direction is reduced. Therefore, a swinging of the movable unit 55 like a pendulum can be prevented, and thereby the stability of movement operation of the movable unit 55 can be enhanced. Therefore, the position of the DMD 551 can be controlled with higher precision or accuracy.

Further, in the embodiment, the top plate 511 and the base plate 512, formed of magnetic material, function as the yoke plates and configure the magnetic circuit with the position-detection magnet 541 used for the position detection system, with which the influence of the magnetic field generated by the drive unit to the position detection system is reduced. Therefore, the movement control unit 12 can detect the position of the DMD 551, shifted with a higher speed, with higher precision or accuracy based on the output of the Hall element 542, and can control the position of the DMD 551 with enhanced precision or accuracy.

As above described, the position detection system PS can be applied to a projector or the like. More specifically, in one example case of FIG. 14, the position detection system PS can be implemented or devised, for example, by the Hall element 542 and the position-detection magnet 541. A description is given of a schematic configuration of the position detection system PS with reference to FIG. 15.

FIG. 15 is a schematic configuration of the position detection system PS of the embodiment. As illustrated in FIG. 15, the position detection system PS includes, for example, a first magnet 541a, and second magnet 541b as the position-detection magnet 541, in which the first magnet 541a and the second magnet 541b are spaced apart by setting an interval between the first magnet 541 a and the second magnet 541b, and polarities of the first magnet 541 a and the second magnet 541b directed towards the Hall element 542 are set differently to form a magnetic field M by the first magnet 541a and the second magnet 541b. As illustrated in an example case of FIG. 15, it is assumed that the Hall element 542 is disposed on a movable member such as the movable unit 55. In this example case, it is assumed that the position-detection magnet 541 is fixed at a position with respect to the Hall element 542.

Further, the position detection system PS includes, for example, an analog voltage processing device ANM that performs processing to a detection voltage output by the Hall element 542. Further, the position detection system PS includes, for example, an AD converter ADM that performs an analog-digital (AD) conversion. Further, the position detection system PS includes, for example, a calculator CLM that performs various processing such as a detection processing of a position of the movable unit. Further, the position detection system PS can include, for example, a controller CTM that controls the movement of the movable unit. For example, the analog voltage processing device ANM, the AD converter ADM, the calculator CLM, and the controller CTM can be configured as an electronic circuit and an AD converter, in which the electronic circuit may be configured by hardware components similar to the hardware components of the system control unit 10 illustrated in FIG. 2B.

As illustrated in FIG. 15, the position-detection magnet 541 generates a magnetic field M. Specifically, the magnetic field M is generated in an arc shape from the second magnet 541b toward the first magnet 541a. Then, the Hall element 542 detects a vertical component of the magnetic field M, which is a component of the magnetic field M in the Z-axis direction in FIG. 15, and outputs a detection voltage, corresponding to an absolute value of the magnetic flux density of the magnetic field M effecting the Hall element 542, as a detection result to the analog voltage processing device ANM. Specifically, the detection voltage is, for example, a Hall voltage as below described.

FIG. 16 is a schematic view illustrating the Hall voltage of the embodiment. Specifically, the Hall voltage is a voltage calculated by the following formula (1).

$$V_H = R_H \frac{I \times |B|}{d} \qquad (1)$$

In the formula (1), "$V_H$" denotes the Hall voltage. Further, "I denotes a current value flowing in the Y axis direction. Further, in FIG. 16, the current indicated by "I" flows from "Iin" toward "Iout." Further, "B" denotes the magnetic flux density of the magnetic field M effecting the Hall element 542 in the Z-axis direction, and "|B|" denotes an absolute value of the magnetic flux density of the magnetic field M effecting the Hall element 54 in the Z-axis direction. Further, "d" denotes the thickness of the Hall element 542. Further, "$R_H$" denotes the Hall constant, which is a constant determined by physical properties and/or temperature of the Hall element 542.

As indicated in the formula (1), the Hall voltage $V_H$ is proportional to the absolute value of the magnetic flux density |B|, in which the plus or minus sign of Hall voltage $V_H$ is determined by the direction of the magnetic field M. Further, the displacement of the movable unit and the detection voltage can be correlated as below described.

FIG. 17 illustrates an example of a characteristic relationship of the displacement and the Hall voltage of the embodiment with illustrations of (A), (B), (C) and (D). Hereinafter, for the simplicity of the description, the illustrations of (A), (B), (C) and (D) of FIG. 17 are respectively referred to as FIG. 17(A), FIG. 17(B), FIG. 17(C) and FIG. 17(D). In FIG. 17(A), the horizontal axis indicates the displacement of the movable unit (hereinafter, "displacement DP"), and the vertical axis indicates the Hall voltage $V_H$ calculated by using the formula (1).

For example, as illustrated in FIG. 17(B) to FIG. 17(D), it is assumed that the movable unit disposed with the Hall element 542 moves relative to the first magnet 541a and the second magnet 541b. Specifically, FIG. 17(C) illustrates an initial position of the Hall element 542 with respect to the first magnet 541 a and the second magnet 541b, and the displacement DP is set "0 mm" for the initial position of the Hall element 542 as illustrated in FIG. 17(A). At the initial position, the upward component and the downward component of the magnetic flux passing through the Hall element 542 cancel with each other, in which the Hall voltage $V_H$ becomes "0 V." A description is given by using the initial position as a reference point.

First, a case that the displacement DP decreases from "0 mm" when the Hall element 542 moves to the left in FIG. 17(A) is described. In this case, the displacement DP decreases from "0 mm," for example, when the movable unit 55 moves toward the first magnet 541a as illustrated in FIG. 17(B). When the movable unit 55 moves as illustrated in FIG. 17(B), and the displacement DP decreases from "0 mm," the upward component of the magnetic flux passing through the Hall element 542 decreases. Therefore, in the formula (1), the absolute value |B| of the magnetic flux density decreases, and the Hall voltage $V_H$ decreases, which is indicated in the left side of the displacement DP = 0 mm in FIG. 17(A).

Further, another case that the displacement DP increases from "0 mm" when the Hall element 542 moves to the right in FIG. 17(A) is described. In this case, the displacement DP increases from "0 mm," for example, when the movable unit 55 moves toward the second magnet 541b as illustrated in FIG. 17(D). When the movable unit 55 moves as illustrated in FIG. 17(D) and the displacement DP increases, the upward component of the magnetic flux passing through the Hall element 542 increases. Therefore, in the formula (1), the absolute value |B| of the magnetic flux density increases, and the Hall voltage $V_H$ increases, which is indicated in the right side of displacement DP = 0 mm in FIG. 17(A).

Further, the displacement and the voltage have the following feature or characteristics. Specifically, the displacement and the voltage have a linearity relationship setting an initial position, which is the point that the Hall voltage $V_H$ is "0 V," as the center of linearity relationship. Specifically, in an example case illustrated in FIG. 17, the displacement and the voltage have the linearity relationship from a position where the displacement DP is "lin-min" (i.e., minimum displacement for the linearity portion) to a position where the displacement DP becomes "lin-max" (i.e., maximum displacement for the linearity portion). The maximum displacement for a range that can maintain the linearity relationship is defined as "lin-max" while the minimum displacement for the range that can maintain the linearity is defined as "lin-min." The Hall voltage $V_H$ when the displacement DP is "lin-max" is referred to "$V_H$-max" and the Hall voltage $V_H$ when the displacement DP is "lin-min" is referred to "$V_H$-min."

Further, as illustrated in FIG. 17, the relationship of the displacement and the voltage have a point symmetry relationship by setting the point where the Hall voltage $V_H$ becomes "0 V" as the center. Therefore, each of the values have the point symmetry relationship such as "$|V_H\text{-max}| = |V_H\text{-min}|$."

(Process of detecting position)

FIG. 18 is a flow chart illustrating the steps of a first example process of detecting a position of the movable unit. For example, the sequence of FIG. 18 is performed to detect the positions of the movable unit as illustrated in FIG. 17.

At step S01, a gain value is set to the position detection system PS. For example, the gain value can be set by a user. The gain value set at step S01 has a following effect.

FIG. 19 schematically illustrates example profiles indicating an effect of the gain value. In an example case illustrated in FIG. 19, similar to an example case of FIG. 17(A), the horizontal axis indicates the displacement DP and the vertical axis indicates a voltage corrected from the Hall voltage based on the gain value (hereinafter, corrected voltage Vcor). In this example case of FIG. 19, the relation of displacement and the corrected voltage is indicated by a profile. The profile includes a straight line portion as illustrated in FIG. 19. The straight line portion of the profile has linearity for the displacement and the corrected voltage. In an example case illustrated in FIG. 19, it is assumed that the corrected voltage Vcor becomes "0 V" to "3 V" for the straight line portion having the linearity for the displacement and the corrected voltage.

Further, in this description, an analog-digital converted (AD) value per displacement is defined as "detection sensitivity SC (μm/AD)," in which when the detection sensitivity SC becomes a smaller value, the detection precision of position becomes higher. The detection sensitivity SC can be also referred to as resolution. In this description, the AD value is a value related to the resolution when analog voltage values are converted to digital values. For example, when an AD converter converts the analog values to the digital values for a detection range of 3000 mV with 12-bit (2^12 = 4096), one AD value becomes 3000 (mV)/4096 = 0.73 (mV). In this description, the Hall element 542 is used to correlate the movement distance of the movable member and the detection voltage. For example, when the movable member moves for Δμm, the detection voltage changes for ΔmV. Then, the AD converts the detection voltage (i.e., analog value) to a digital value such as the AD value. In this configuration, the movement distance of the movable member per one AD value can be expressed by "μm/mV." Since the processor or circuitry regards the analog value (mV) as a digital value such as the AD value, the detection sensitivity SC (μm/AD) is used in this description.

For example, the gain value can be changed when a current value (corresponding to "I" in the formula (1)) that flows in the Hall element 542 is changed. Hereinafter, a description is given of two gain values (i.e., current values) such as a first gain value G1 and a second gain value G2, in which the second gain value G2 is set greater than the first gain value G1.

Therefore, a characteristic profile for the first gain value G1 has a sharp inclination compared to a characteristic profile for the second gain value G2 as illustrated in FIG. 19. When the inclination becomes steeper, the detection sensitivity SC becomes a smaller value and the detection precision of position increases whereas a detectable range that can detect the displacement DP for the first gain value G1 becomes a first detection range RG1 as illustrated in FIG. 19.

Further, when the gain value is the second gain value G2, the detection precision of position for the second gain value G2 becomes lower than the detection precision of position for the first gain value G1 whereas a detectable range that can detect the displacement DP for the second gain value G2 becomes a second detection range RG2 as illustrated in FIG. 19. As illustrated in FIG. 19, the second detection range RG2 is wider than the first detection range RG1. Therefore, the detection precision of position and the detectable range of the displacement DP have a trade-off relationship.

A description is returned to FIG. 18. At step S02, an offset value is set to the position detection system PS. The offset value set at step S02 has a following effect.

FIG. 20 schematically illustrates example profiles indicating an effect of the offset value. Similar to FIG. 19, in FIG. 20, the horizontal axis indicates the displacement DP and the vertical axis indicates the corrected voltage Vcor. Further, similar to an example case of FIG. 19, in an example case illustrated in FIG. 20, it is assumed that the displacement DP can be detected by maintaining the linearity when the corrected voltage Vcor is within the range of "0V" to "3V."

When the offset value becomes different values, profiles indicating the relationship of the displacement DP and the corrected voltage Vcor becomes different. In an example case illustrated in FIG. 20, when a first offset value is set, the relationship of the displacement DP and the corrected voltage Vcor becomes a first characteristic δ, and when a second offset value is set, the relationship of the displacement DP and the corrected voltage Vcor becomes a second characteristic α. Further, when a third offset value is set, the relationship of the displacement DP and the corrected voltage Vcor becomes a third characteristic γ. In an example case of FIG. 20, the profiles indicating the first characteristic δ, the second characteristic α, and the third characteristic γ are set from the left to right in FIG. 20.

As illustrated in FIG. 20, when the offset value becomes different values, the relationship of the displacement DP and the corrected voltage Vcor becomes different. Specifically, when the displacement DP is "0 mm" in the second characteristic α, the corrected voltage Vcor becomes "1.5V." When the second characteristic α is used, the detectable range of the displacement DP becomes "αlin-min" to "αlin-max" as illustrated in FIG. 20.

By contrast, when the offset value is the first offset value, the first characteristic δ is used. In a case of the first characteristic δ, the corrected voltage Vcor is set to "0V" when the displacement DP becomes "δlin-min."

Further, when the offset value is the third offset value, the third characteristic γ is used. In a case of the third characteristic γ, the corrected voltage Vcor is set to "3V" when the displacement DP becomes "γlin-max."

As indicated in FIG. 20, the inclination of each straight line portion of each of the profiles has the same inclination. Therefore, a width of the range that can detect the displacement DP becomes the same for each of the profiles as indicated as the detection range RG in FIG. 20. Therefore, even if the offset value is changed and thereby the characteristic is changed, the detection sensitivity SC does not decrease, which means the precision of position detection can be maintained. As above described, the offset value can be used as a value to set the characteristic relationship of the displacement and the corrected voltage.

At step S03, the position detection system PS outputs a detection voltage by using the Hall element 542. Specifically, as illustrated in FIG. 17, the Hall element 542 detects a change of the magnetic flux density of the magnetic field corresponding to a change of the displacement DP, and outputs the Hall voltage $V_H$ calculated by using the formula (1).

At step S04, the position detection system PS generates a corrected voltage based on the gain value and the offset value respectively set at step S01 and step S02. Specifically, when the gain value is set, the inclination is set as illustrated in FIG. 19. Further, when the offset value is set, the characteristic is set as illustrated in FIG. 20. With this configuration, the position detection system PS can set a detection range for detecting the position and the precision of detecting the position.

At step S05, the position detection system PS performs the AD conversion to the corrected voltage generated at step S04. Specifically, the AD converter ADM performs the AD conversion to the corrected voltage to convert the corrected voltage (i.e., analog value) to a digital value such as the above described AD value.

At step S06, the position detection system PS calculates a position of the movable member such as the movable unit 55 based on the digital value generated at step S05.

For example, the calculator CLM is input with a data set prepared as table-format data that correlates the digital values and the displacement in advance. Then, the calculator CLM specifies or identifies the displacement corresponding to the digital value generated at step S05 by referring the data set (e.g., table-format data), and detects the position of the movable unit 55 based on the specified or identified displacement.

Then, the position detection system PS changes the detection range used for detecting the displacement DP to detect the displacement using a wider detection range. Specifically, when the detection range is to be changed, the following sequence is performed.

FIG. 21 is a flow chart illustrating a second example process of detecting a position of the embodiment. Specifically, the sequence illustrated in FIG. 21 is performed after the sequence of FIG. 18 was performed. Therefore, the sequence illustrated in FIG. 21 is performed when the gain value and the offset value are already set by performing the sequence of FIG. 18. In the following description, the sequence in FIG. 21 similar to the sequence in FIG. 18 is assigned with the same references, and the redundant description is omitted. Compared to the sequence of FIG. 18, the sequence of FIG. 21 is different by performing step S11 and step S12.

At step S11, the position detection system PS determines whether the detection range is to be changed. When the position detection system PS determines that the detection range is to be changed (step S11: YES), the position detection system PS proceeds the sequence to step S12. By contrast, when the position detection system PS determines that the detection range is not to be changed (step S11: NO), the position detection system PS proceeds the sequence to step S03.

At step S12, the position detection system PS changes the offset value. Specifically, step S11 and step S12 are performed as below.

FIG. 22 illustrates an example of an arrangement of the position-detection magnets 541 of the embodiment. Hereinafter, as illustrated in FIG. 22, it is assumed that three sets of the position-detection magnet 541 are set as indicated by the dot lines in FIG. 22. In this example arrangement, the offset value is used to specify which one of the position-detection magnets 541 is used for the position detection operation. Therefore, the three characteristics of the first characteristic δ, the second characteristic α, and the third characteristic γ illustrated in FIG. 20 are respectively detected by using the three sets of position-detection magnets 541 illustrated in FIG. 22. Therefore, as indicated in FIG. 22, the number of characteristics can be changed by changing the number of position-detection magnets 541.

Further, the arrangement configuration of the position-detection magnets 541 is not limited to an example configuration illustrated in FIG. 22. For example, the number of the position-detection magnets 541 is not required to be three sets of magnets, but the number of the position-detection magnets 541 can be one set of magnets, in which the position-detection magnet 541 is moved to the position corresponding to any one of "δ", "α" and "γ", with which the number of position-detection magnets 541 can be reduced.

FIG. 23 illustrates an example of a plurality of detection ranges of the embodiment, which can be changed one to another as required. Hereinafter, similar to an example case of FIG. 22, the first characteristic δ, the second characteristic α, and the third characteristic γ are set and described. Specifically, the position detection system PS changes the offset value to switch the characteristic, and then changes the detection range based on the characteristic (step S12).

Further, the position detection system PS is input with the data set prepared as the table-format data that correlates the digital values and the displacement DP for each of the characteristic in advance. Specifically, in an example case illustrated in FIG. 23, the position detection system PS is input with the data set including a plurality of data groups such as "δ table" for the first characteristic δ, "α table" for the second characteristic α, and "γ table" for the third characteristic γ.

Then, when the position detection system PS detects a position based on the digital value (step S06), the position detection system PS refers to the offset value set at step S12 to determine which one of the table-format data is used. Specifically, when the first offset value is set, the position detection system PS detects a position by using the "δ table." Further, when the second offset value is set, the position detection system PS detects the position by using the "α table." Further, when the third offset value is set, the position detection system PS detects the position by using the "γ table."

Further, for example, when the digital value becomes a given value, the position detection system PS determines that the detection range is to be changed (step S 11: YES). In an example case illustrated in FIG. 23, when the digital value becomes "4095"or "0", the position detection system PS changes the offset value (step S12).

With this configuration, the position detection system PS can widen the detection range used for detecting the position while maintaining the linearity. Specifically, in an example case illustrated in FIG. 23, the position detection system PS can detect the displacement DP from "δlin-min" to "γlin-max." Further, when the offset value is changed to widen the detection range, the detection sensitivity SC can be maintained compared to the case illustrated in FIG. 19 that detects the position by changing the gain values, and thereby the position can be detected with enhanced precision or accuracy in the example case illustrated in FIG. 23.

Further, the position detection system PS can change the gain value that is the current value in the formula (1). In this case, the data set employs a format that correlates the current value, the digital value, and the displacement DP.

Further, the data set is not required to employ the table format data such as a look-up table (LUT). Specifically, the format of the data set can be any format that the position detection system PS can specify or identify the displacement based on the digital value. When such data set is used, the position detection system PS can detect the position by referring the data set, and can shorten the calculation time for detecting the position.

Further, the position detection system PS can detect the position without using the above described data set. For example, the position detection system PS can preset values for the AD converter ADM, and the detection sensitivity SC corresponding to each of the values preset for the AD converter ADM, and stores the values preset for the AD converter ADM and the detection sensitivity SC in advance as initial values. With this configuration, the position detection system PS can calculate the displacement DP by applying the detection sensitivity SC. For example, the position detection system PS can detect a position of the movable member by using the following formula (2), in which "G" denotes a gain value.

$$DP = \frac{(G \times V_H + V_{off}) - V_{off-bs}}{4096} \times SC \qquad (2)$$

For example, in a case of the displacement DP corresponding to "αlin-min" illustrated in FIG. 23, the position detection system PS sets one detection sensitivity SC as an initial value such that the detection voltage $V_H$ becomes "0 V" or "3 V." In the formula (2), "Voff" is a voltage corresponding to the offset value, and "Voff-bs" is an initial value of "Voff." When the calculation is performed by using the formula (2), the displacement DP per one digital value can be calculated. Further, the offset value can be acquired from the controller CTM (FIG. 15).

Further, the position detection system PS can detect the position by using the following formula (3), in which "G" denotes a gain value.

$$DP = \frac{I_{ref-bs}}{I_{ref}} \times \frac{(G \times V_H + V_{off}) - V_{off-bs}}{4096} \times SC \qquad (3)$$

Compared to the formula (2), the formula (3) is different from the formula (2) that the change in the current value in the formula (1) is taken into consideration for the formula (3). Specifically, in the formula (3), "Iref-bs" is an initial current value while "Iref "is a current value after the change of the current value.

Further, the value of "4096" set in the formula (2) and the formula (3) corresponds to "$2^{12}$ = 4096" and the value of "4096" corresponds to the number of the digital values that the AD converter ADM (FIG. 15) can output.

With this configuration, the position detection system PS can detect the position without using the data set prepared as the table-format data. Therefore, the position detection system PS can reduce the data amount such as the table format data, and thereby the position detection system PS can reduce a memory consumption used for storing the data.

(Second embodiment)

A description is given of a second embodiment. The second embodiment is implemented with the same hardware configuration used for the first embodiment. Compared to the first embodiment, the second embodiment performs a different sequence. Hereinafter, differences from the first embodiment will be mainly described, and redundant description will be omitted. Specifically, instead of the sequence illustrated in FIG. 21, the following sequence is performed for the second embodiment as illustrated in FIG. 24.

FIG. 24 is a flow chart illustrating the steps of a third example process of detecting a position of the second embodiment. Compared to the sequence illustrated in FIG. 21, step S21 and step S22 are performed in the sequence illustrated in FIG. 24. In FIG. 24, the same reference numerals are given to the same processes illustrated in FIG. 21, and redundant description will be omitted.

At step S 21, the position detection system PS determines whether the digital value is increasing. Specifically, when the position detection system PS generates the digital value such as the AD value by performing the AD conversion (step S05 in FIG. 18), the digital value is stored. Hereinafter, the stored digital value is referred to as "previous digital value" because the stored digital value was acquired by the previous processing. The sequence illustrated in FIG 24 can be performed periodically with a given time interval, and the previous digital value is a value generated in the previous processing that was performed before the current processing is performed. Hereinafter, the most recent digital value of the previous digital value is referred to as "the latest digital value."

Next, at step S 21, the position detection system PS determines whether the latest digital value is greater than the previous digital value generated before the latest digital value. When the position detection system PS determines that the latest digital value is greater than the previous digital value, the position detection system PS determines that the digital value is increasing (Step S21: YES). By contrast, when the position detection system PS determines that the latest digital value is not greater than the previous digital value, the position detection system PS determines that the digital value is not increasing (step S21: NO).

As above described, the position detection system PS determines a changing trend of the digital value. Specifically, in this example case, the position detection system PS determines whether the displacement DP has a changing trend that moves towards the right direction in FIG. 23 (corresponding to the downward direction in the table). Further, step S21 is not limited to the above method. Specifically, step S21 can be performed differently if the position detection system PS can determine the changing trend of the digital value. For example, an average value of multiple previous digital values can be used at step S21.

Then, when the position detection system PS determines that the digital value is increasing (step S21: YES), the position detection system PS proceeds the sequence to step S22. By contrast, when the position detection system PS determines that the digital value is not increasing (step S21: NO), the position detection system PS proceeds the sequence to step S03.

At step S 22, the position detection system PS determines whether the digital value is within a given range. Specifically, the position detection system PS performs the following process.

FIG. 25A illustrates another example of a plurality of detection ranges of the third embodiment, which can be changed one to another. Hereinafter, an example of switching the "$\alpha$ table" and "$\delta$ table" (see FIG. 23) is described. In an example case illustrated in FIG. 25A, for example, four digital values "4092" to "4095" in the "$\delta$ table" are used as a given range CO. Further, four digital values "0" to "4" in the "$\alpha$ table" are used as the given range CO. As illustrated in FIG. 25A, the given range CO has the same to-be-detected displacement DP in both of the "$\alpha$ table" and "$\delta$ table," which means the given range CO is the common range for both of the "$\alpha$ table" and "$\delta$ table".

At step S 22, the position detection system PS determines whether the latest digital value is within the given range. Specifically, when the "$\delta$ table" is set, the position detection system PS determines whether the latest digital value is within the given range CO by checking whether the latest digital value is "4092" or more. Then, in this example case, when the position detection system PS determines that the latest digital value is within the given range CO (step S22: YES), the position detection system PS changes the offset value (step S12), and switches the "$\delta$ table" to the "$\alpha$ table."

The given range CO can be set by a user. Specifically, in an example case illustrated in FIG. 25A, the four digital values are used as the given range CO, but the given range CO is not necessarily set by the four digital values. Specifically, is preferable that the given range CO is equal to or greater than a range that the movable unit can move in one detection operation. For example, it is assumed that the movable member moves from "- 2050 (μm)" to "- 2044 (μm)" and then from "- 2044 (μm)" to "-2049(μm)" by setting the displacement DP of "- 2044 (μm)" as the center of the movement when the tables and characteristics are set as illustrated in FIG. 25A. In this case, if the given range CO is set by the four digital values (e.g., - 2048, - 2047, - 2046, - 2045 (μm)), the tables are switched for two times such as from the "δ table" to the "α table" and from the "α table" to the "δ table." In this case, the offset value is changed to change the detection range of the "α table." For example, the offset value is changed to shift the detection range of the "α table," and then the given range CO is set for the "α table" by using the five digital values as illustrated in FIG. 25B. When the given range CO is set for the "α table" by using five digital values as illustrated in FIG. 25B, the movable member can move from "- 2050 (μm)" to "- 2044 (μm)" and then from "- 2044 (μm)" to "- 2049(μm)" by switching the tables for one time such as from the "δ table" to the "α table." Therefore, when it is expected that the table switching is likely to occur frequently, the given range CO is set with a wider range to reduce the number of table switching times.

Further, in the above description, a case of the increase of the displacement DP is described as an example, but the switching of the data can be performed in the opposite direction. Specifically, the data can be switched by determining whether the digital values is decreasing or not.

(Functional block diagram)

FIG. 26 is an example of a functional block diagram of the position detection system PS of the embodiment. As illustrated in FIG. 26, the position detection system PS includes, for example, a magnetic field generation unit PSF1, a magnetic field detection unit PSF2, a voltage generation unit PSF3, an AD conversion unit PSF4, a position detection unit PSF5, and a control unit PSF6.

The magnetic field generation unit PSF1 generates the magnetic field M (FIG. 15). For example, the magnetic field generation unit PSF1 can be implemented or devised by the position-detection magnet 541 (FIG. 14).

When the magnetic field M (FIG. 15) is generated by the magnetic field generation unit PSF1, the magnetic field detection unit PSF2 detects a magnetic flux density B of the magnetic field M effecting the magnetic field detection unit PSF2, and outputs the detection voltage $V_H$ (e.g., Hall voltage) corresponding to the magnetic flux density B of the magnetic field M effecting the magnetic field detection unit PSF2. For example, the magnetic field detection unit PSF2 can be implemented or devised by the Hall element 542 (FIG. 14).

The voltage generation unit PSF3 generates the corrected voltage based on the detection voltage $V_H$ output from the magnetic field detection unit PSF2. For example, the voltage generation unit PSF3 can be implemented or devised by the analog voltage processing device ANM (FIG. 15).

The AD conversion unit PSF4 performs the AD conversion to the corrected voltage generated by the voltage generation unit PSF3 to generate a digital value. For example, the AD conversion unit PSF4 can be implemented or devised by the AD converter ADM (FIG. 15).

The position detection unit PSF5 detects a position of the movable member based on the digital value and the offset value OF. For example, as illustrated in FIG. 26, when a table data DT is input in advance, the position detection unit PSF5 specifies the table data DT based on the offset value OF, and detects the position of the movable member based on the displacement DP correlated to the digital value in the table data DT. Further, the position detection unit PSF5 can detect the position of the movable member based on the displacement DP calculated by using the formula (2) applying the detection sensitivity SC. For example, the position detection unit PSF5 can be implemented or devised by the calculator CLM (FIG. 15).

The control unit PSF6 controls the movable member. Specifically, the control unit PSF6 controls the movement of position of the movable member. For example, the control unit PSF6 can be implemented or devised by the controller CTM (FIG. 15).

In the above described configuration, when the magnetic field M is generated by the magnetic field generation unit PSF1, the magnetic flux density B of the magnetic field M effecting the magnetic field detection unit PSF2 becomes different depending on the displacement DP of the movable member as illustrated in FIG. 17. Therefore, at first, the magnetic field detection unit PSF2 outputs the detection voltage $V_H$ corresponding to the magnetic flux density of the magnetic field M effecting the magnetic field detection unit PSF2. Then, the detection voltage $V_H$ is corrected by using the gain value to generate the corrected voltage. Then, the corrected voltage is processed by the AD conversion to generate the digital value.

As illustrated in FIG. 23, the relationship of the corrected voltage and the displacement DP becomes different depending on which characteristic or which detection range is used for detecting the position of the movable member, in which the detection range is switched based on the offset value OF. Further, based on the offset value OF, the position detection system PS specifies the table data DT to be used by the position detection unit PSF5 for detecting the position of the movable member. With this configuration, as illustrated in FIG. 23, the position detection system PS can detect the position of the movable member by using a wider range.

Further, as illustrated in FIG. 23, the position detection is preferably performed within a portion having the linearity relationship. For example, at a non-linearity portion NLI not having the linearity relationship as illustrated in FIG. 17, the detection voltage becomes "$V_{H1}$" for the displacement "DP1" and the displacement "DP2 as illustrated in FIG. 17. By contrast, when the portion having the linearity relationship is used for the position detection, one detection voltage is not correlated to a plurality of displacements DP, which means the one detection voltage is correlated to one displacement DP alone, with which the position detection system PS can detect the position with enhanced precision or accuracy.

According to the above described embodiments, the position detection system capable of detecting a position of a movable member in a wider range with an enhance precision can be provided.

Further, although the position detection system PS is applied to the projector in the above described embodiments, the position detection system PS can be applied to other devices or apparatuses other than the projector.

Numerous additional modifications and variations for the modules, the units, the image generation units, the image projection apparatuses, and other apparatuses are possible in light of the above teachings. It is therefore to be understood that within the scope of the appended claims, the description of present disclosure may be practiced otherwise than as specifically described herein. For example, elements and/or features of different examples and illustrative embodiments may be combined each other and/or substituted for each other within the scope of present disclosure and appended claims.

Each of the functions of the described embodiments may be implemented by one or more processing circuits or circuitry. Processing circuitry includes a programmed processor, as a processor includes circuitry. A processing circuit also includes devices such as an application specific integrated circuit (ASIC), digital signal processor (DSP), field programmable gate array (FPGA), and conventional circuit components arranged to perform the recited functions.

As described above, the present invention can be implemented in any convenient form, for example using dedicated hardware, or a mixture of dedicated hardware and software. The present invention may be implemented as computer software implemented by one or more networked processing apparatuses. The network can comprise any conventional terrestrial or wireless communications network, such as the Internet. The processing apparatuses can compromise any suitably programmed apparatuses such as a general purpose computer, personal digital assistant, mobile telephone (such as a WAP or 3G-compliant phone) and so on. Since the present invention can be implemented as software, each and every aspect of the present invention thus encompasses computer software implementable on a programmable device. The computer software can be provided to the programmable device using any storage medium for storing processor readable code such as a floppy disk, hard disk, CD ROM, magnetic tape device or solid state memory device.

## Claims

**1.** A position detection system (PS) for detecting a position of a movable member, comprising:

a magnetic field generation unit (PSF1, 541) to generate a magnetic field (M);
a magnetic field detection unit (PSF2, 542) to detect a magnetic flux density (B) of the magnetic field (M) effecting the magnetic field detection unit (PSF2, 542) from the magnetic field generation unit (PSF1, 541), the magnetic flux density (B) of the magnetic field (M) effecting the magnetic field detection unit (PSF2, 542) changeable depending on a change of a position of the magnetic field detection unit (PSF2, 542) relative to a position of the magnetic field generation unit (PSF1, 541), and to output a detection voltage ($V_H$) corresponding to the detected magnetic flux density (B) of the magnetic field (M), the magnetic field detection unit (PSF2, 542) disposed on the movable member; and
at least one processor (101) to

generate a corrected voltage (Vcor) based on the detection voltage ($V_H$) output from the magnetic field detection unit (PSF2, 542);
perform an analog-digital (AD) conversion to the corrected voltage (Vcor) to generate a digital value;
set an offset value (OF) used for specifying a characteristic relationship of the corrected voltage (Vcor) and the digital value;
calculate a displacement of the magnetic field detection unit (PSF2, 542) relative to the magnetic field generation unit (PSF1, 541) by applying the specified characteristic relationship to the digital value; and
detect the position of the movable member based on the calculated displacement of the magnetic field detection unit (PSF2, 542).

**2.** The position detection system (PS) of claim 1, wherein the characteristic relationship is defined by a data set that correlates the digital value and the displacement of the magnetic field detection unit (PSF2, 542) relative to the magnetic field generation unit (PSF1, 541), wherein the data set includes a plurality number of the digital value and a plurality number of the displacement correlating each of the plurality number of the digital value and each of the plurality number of the displacement.

**3.** The position detection system (PS) of claim 2, wherein the data set is specified by the offset value (OF).

**4.** The position detection system (PS) of claim 2 or claim 3, wherein the data set includes a plurality of data groups respectively set for a plurality of detection ranges used for detecting the displacement of the magnetic field detection unit (PSF2, 542) relative to the magnetic field generation unit (PSF1, 541), wherein when the digital value becomes a given value, the data group is switched from one data group to another data group.

**5.** The position detection system (PS) of claim 2 or claim 3, wherein the data set includes a plurality of data groups respectively set for a plurality of detection ranges used for detecting the displacement of the magnetic field detection unit (PSF2, 542) relative to the magnetic field generation unit (PSF1, 541), wherein when the digital value becomes a value within a given range, the data group is switched from one data group to another data group based on a changing trend of the digital value.

**6.** The position detection system (PS) of any one of claims 1 to 5, wherein the detection voltage ($V_H$), output within a portion where the displacement of the magnetic field detection unit (PSF2, 542) relative to the magnetic field generation unit (PSF1, 541) and the detection voltage ($V_H$) have a linearity relationship, is used for detecting the displacement of the magnetic field detection unit (PSF2, 542) relative to the magnetic field generation unit (PSF1, 541).

**7.** The position detection system (PS) of claim 1, wherein the characteristic relationship is defined by an formula applying a detection sensitivity (SC) used for detecting the displacement of the magnetic field detection unit (PSF2, 542) relative to the magnetic field generation unit (PSF1, 541).

**8.** An image generation unit (50) comprising:

the position detection system (PS) of any one of claims 1 to 7; and
an image generation element (551) to receive light and to generate an image based on the received light.

**9.** An image projection apparatus (1) comprising:

the image generation unit (50) of claim 8;
a light source (30) to emit light to the image generation element (551); and
a projection unit (60) to project the image generated by the image generation element (551).

**10.** A method of detecting a position of a movable member, comprising:

generating a magnetic field (M) by using a magnetic field generation unit (PSF1, 541);
detecting a magnetic flux density (B) of the magnetic field (M) generated by the magnetic field generation unit (PSF1, 541) by using a magnetic field detection unit (PSF2, 542), the magnetic flux density (B) of the magnetic field (M) effecting the magnetic field detection unit (PSF2, 542) changeable depending on a change of a position of the magnetic field detection unit (PSF2, 542) relative to a position of the magnetic field generation unit (PSF1, 541), the magnetic field detection unit (PSF2, 542) disposed on the movable member;
outputting a detection voltage ($V_H$) corresponding to the detected magnetic flux density (B) of the magnetic field (M) from the magnetic field detection unit (PSF2, 542);
generating a corrected voltage (Vcor) based on the detection voltage ($V_H$) output from the magnetic field detection unit (PSF2, 542);
performing an analog-digital (AD) conversion to the corrected voltage (Vcor) to generate a digital value;
setting an offset value (OF) used for specifying a characteristic relationship of the corrected voltage (Vcor) and the digital value;
calculating a displacement of the magnetic field detection unit (PSF2, 542) relative to the magnetic field generation unit (PSF1, 541) by applying the specified characteristic relationship to the digital value; and
detecting the position of the movable member based on the calculated displacement of the magnetic field detection unit (PSF2, 542).

FIG. 1

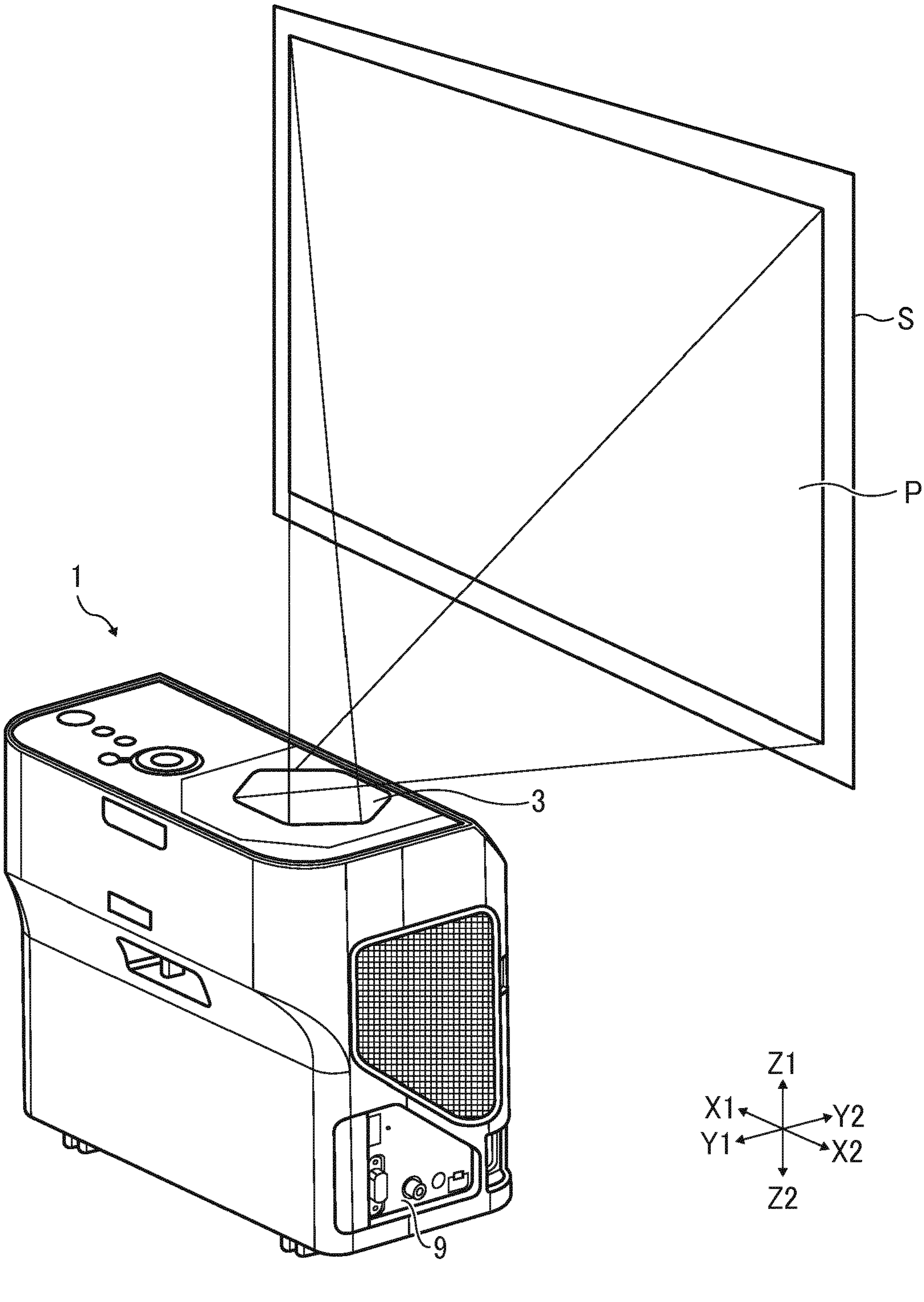

FIG. 2A

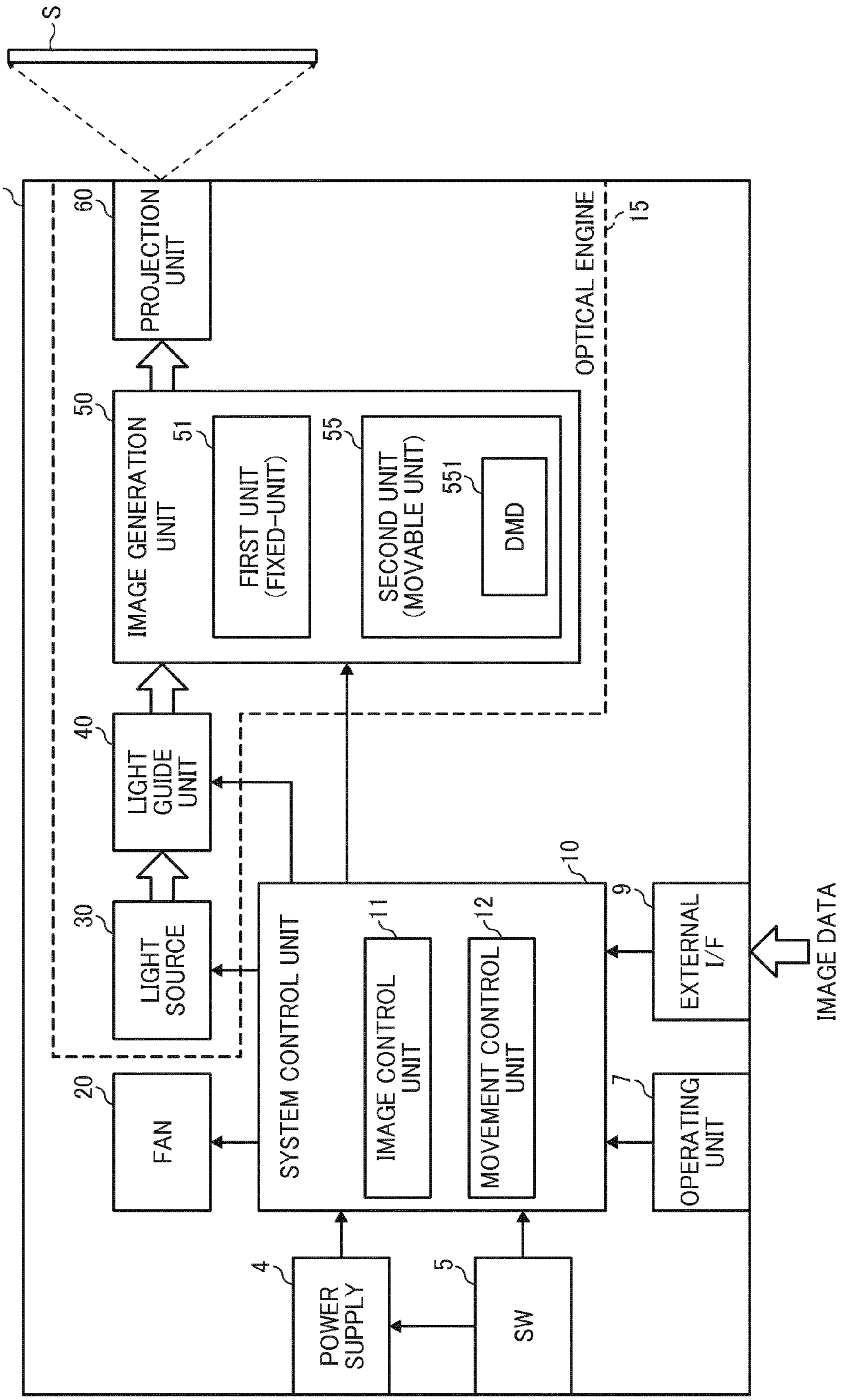
S
1
60
PROJECTION UNIT
OPTICAL ENGINE
15
50
IMAGE GENERATION UNIT
51
FIRST UNIT (FIXED-UNIT)
55
SECOND UNIT (MOVABLE UNIT)
551
DMD
40
LIGHT GUIDE UNIT
30
LIGHT SOURCE
20
FAN
10
SYSTEM CONTROL UNIT
11
IMAGE CONTROL UNIT
12
MOVEMENT CONTROL UNIT
9
EXTERNAL I/F
IMAGE DATA
7
OPERATING UNIT
4
POWER SUPPLY
5
SW

FIG. 2B

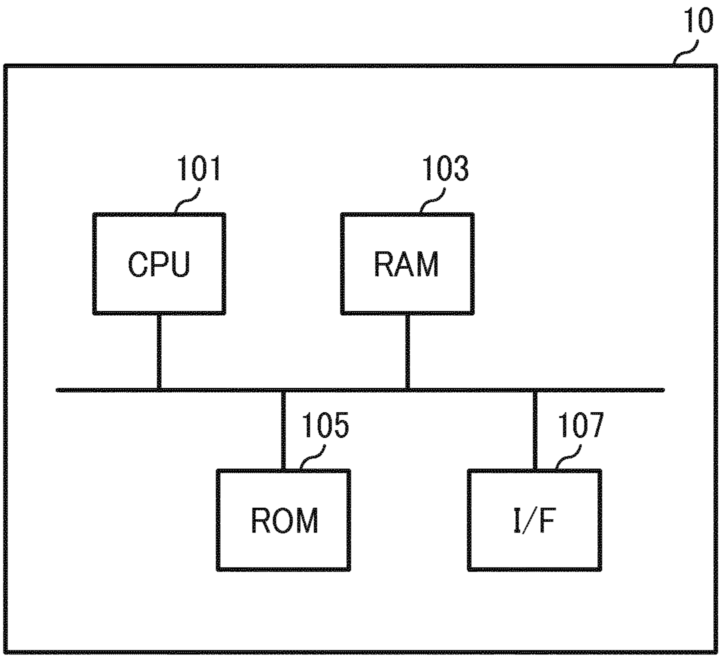

FIG. 3

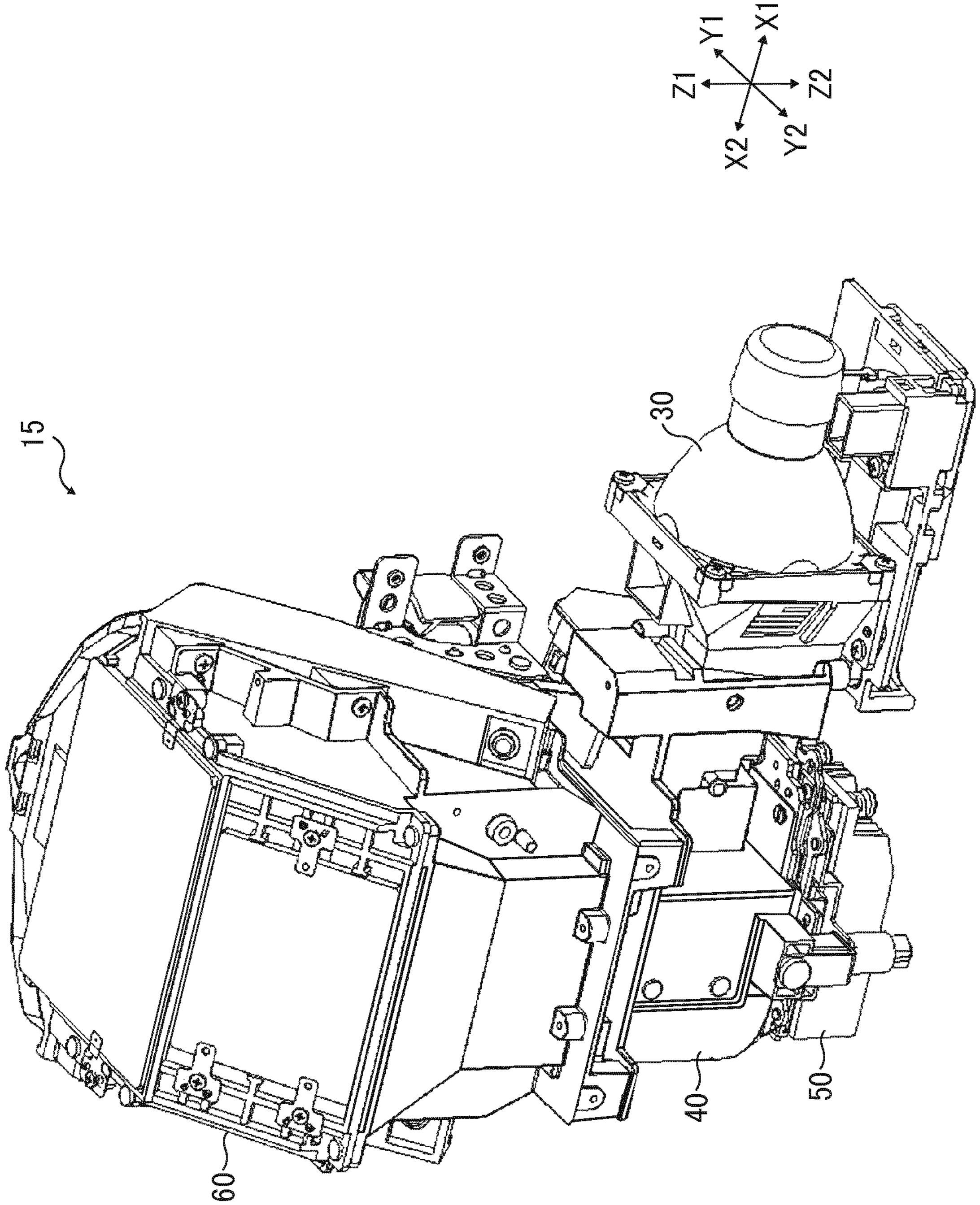

FIG. 4

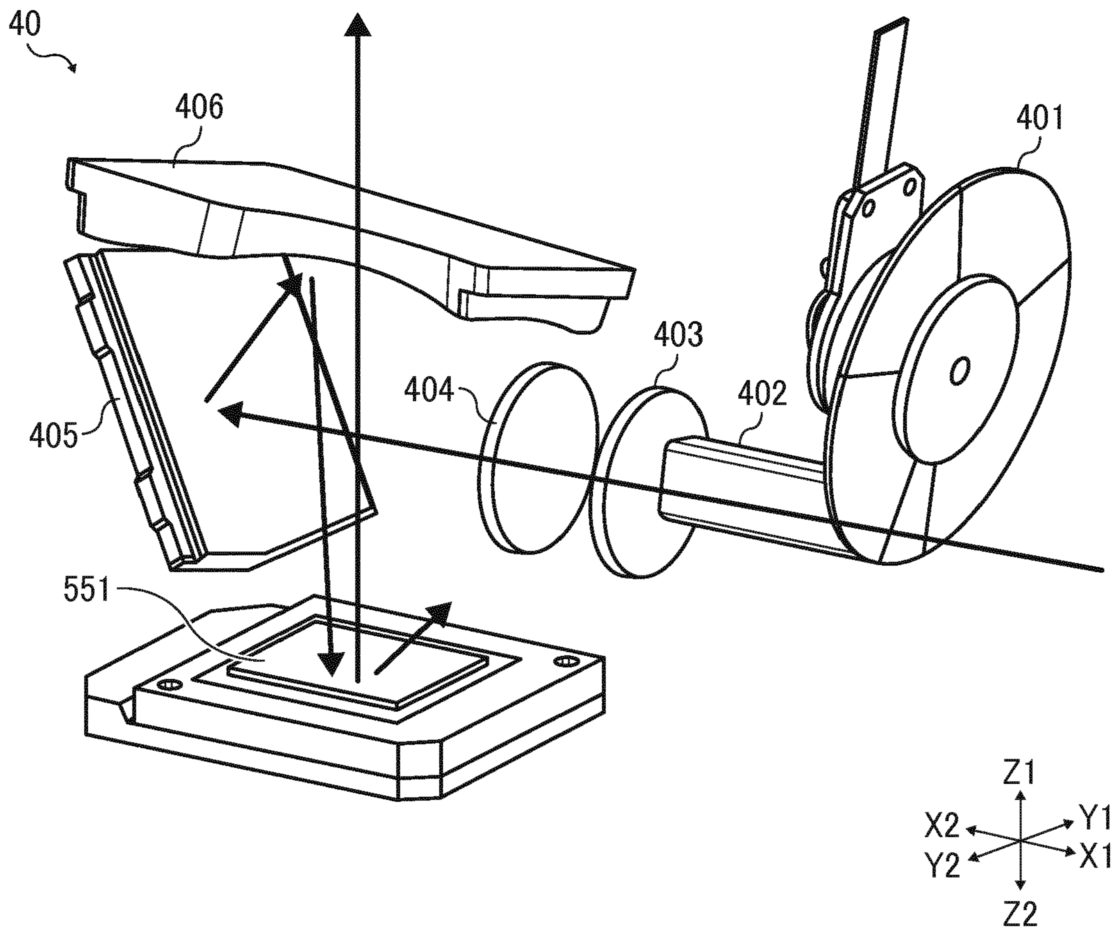

FIG. 5

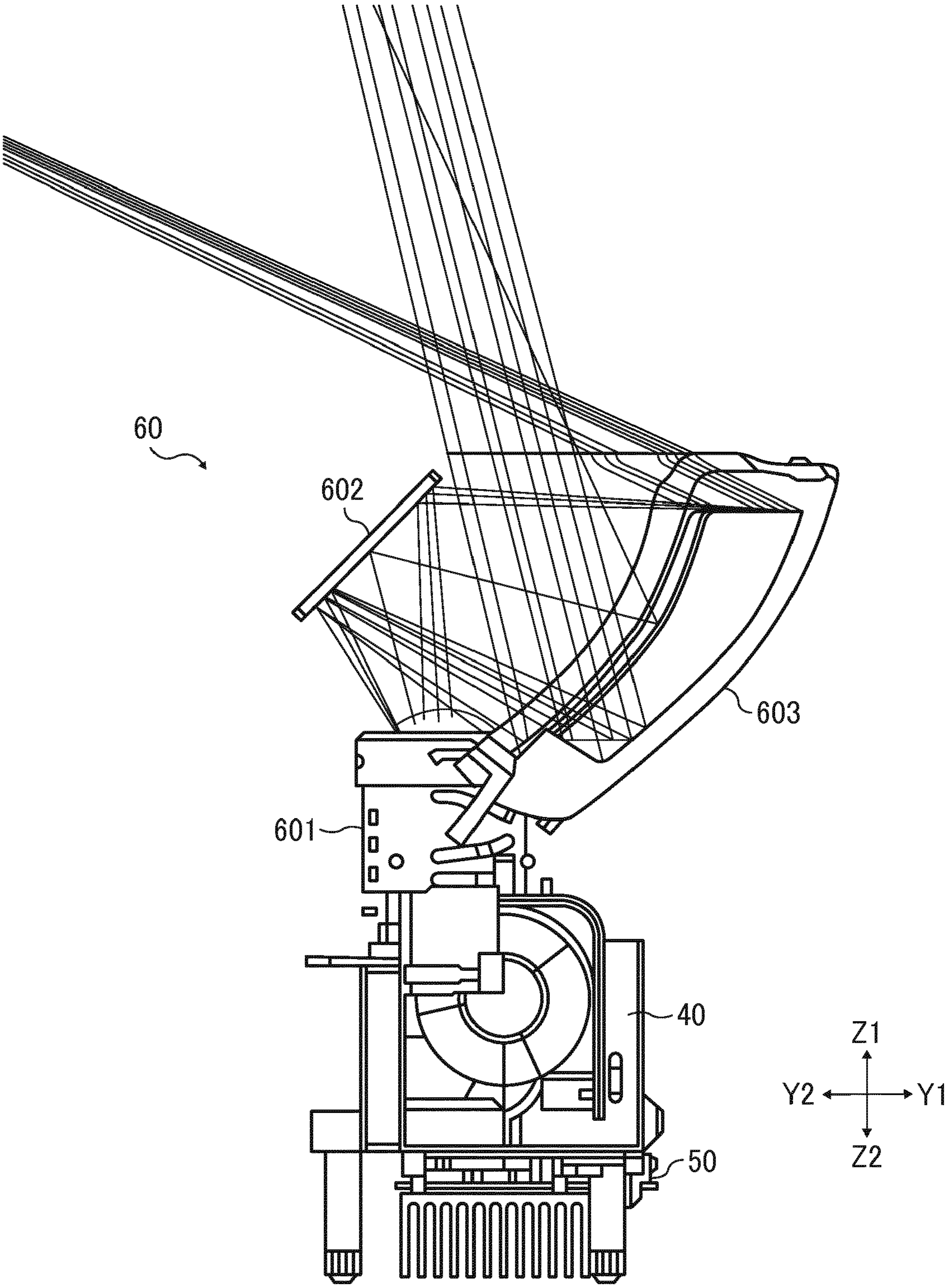

FIG. 6

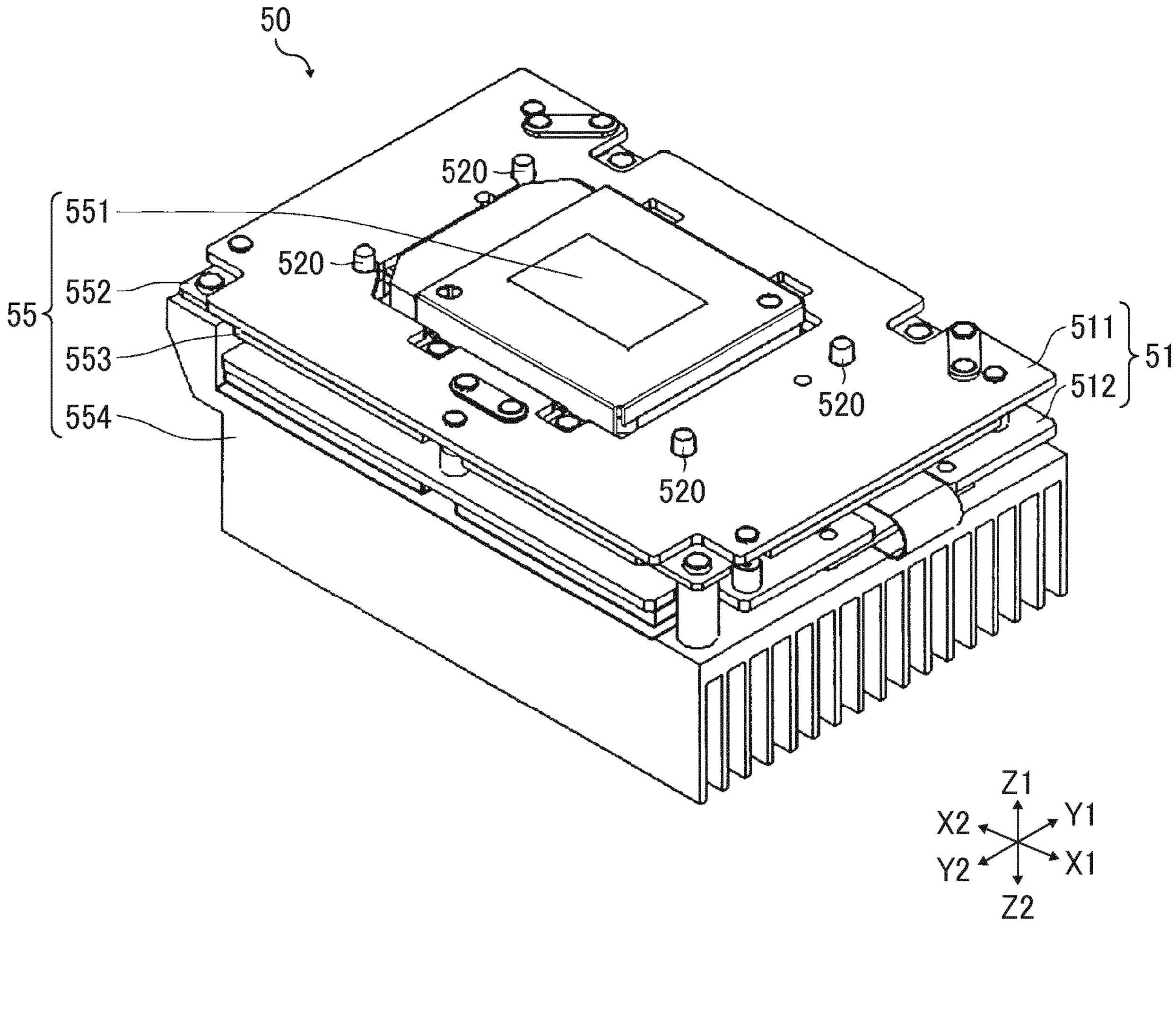

FIG. 7

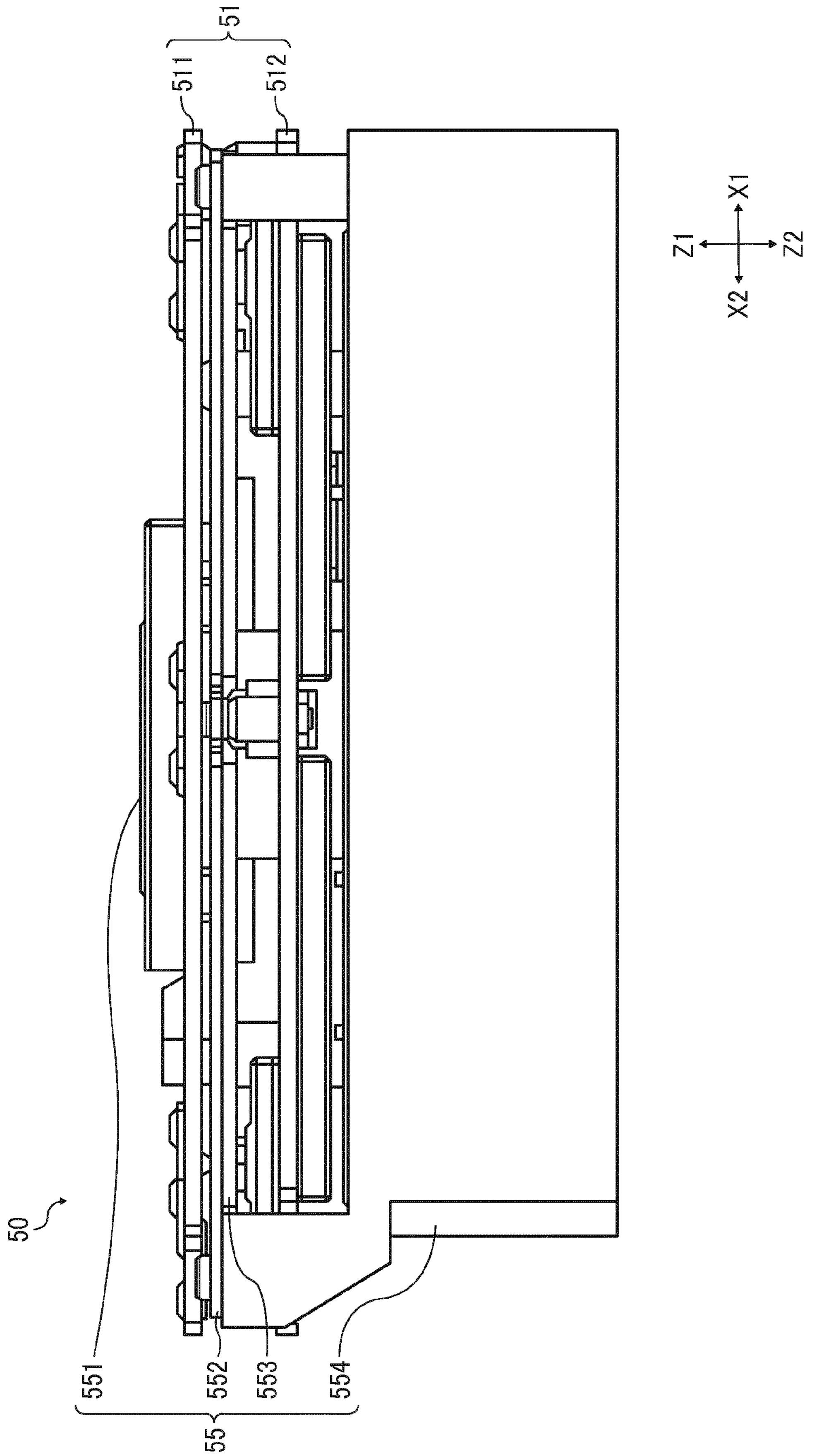

FIG. 8

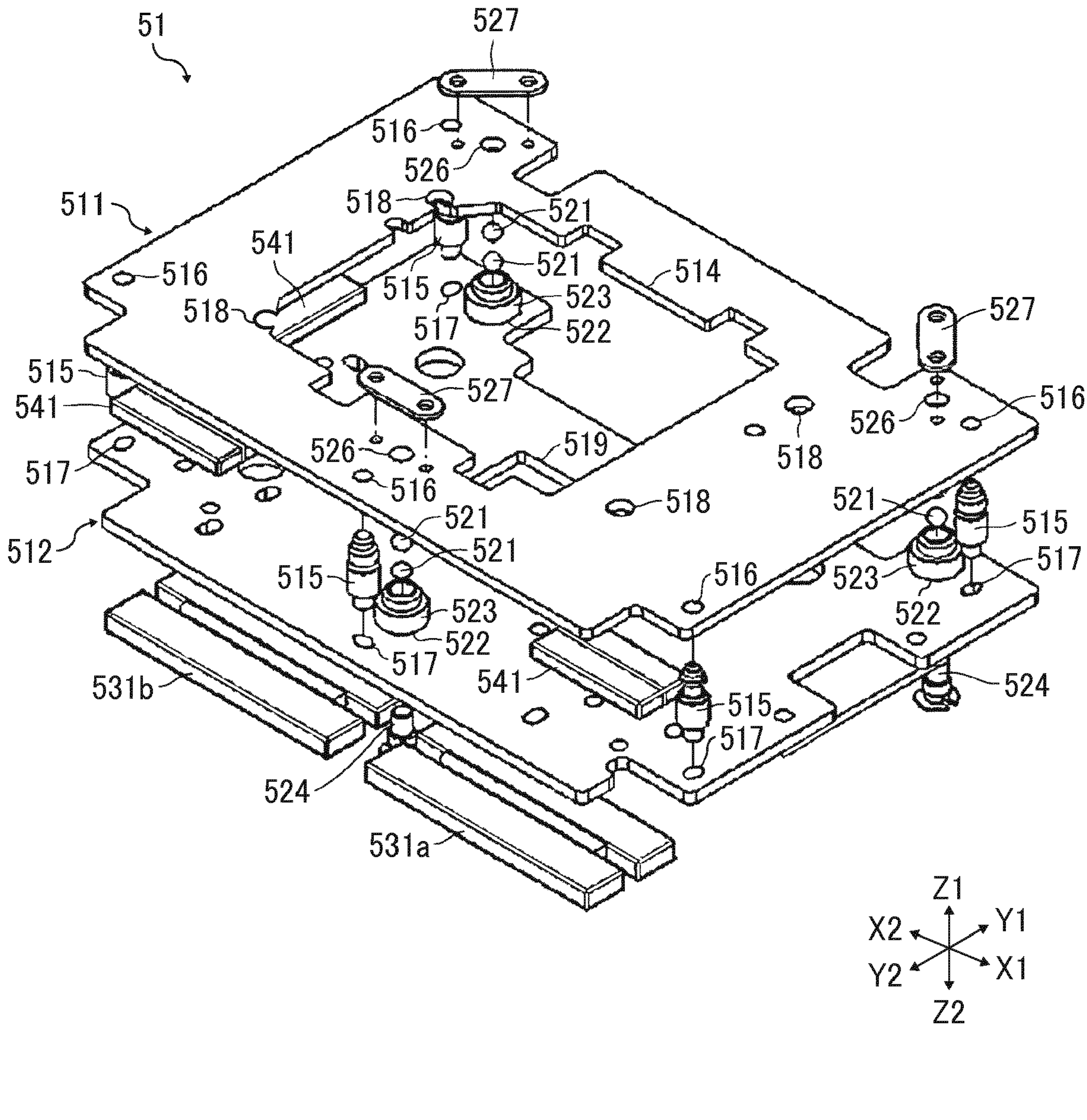
51
527
516
526
511
518
521
541
521
515
523
514
518
517
522
527
515
541
527
516
526
518
517
526
519
516
518
512
521
521
515
517
515
523
523
522
517
522
531b
541
524
515
524
517
531a
Z1
X2
Y1
Y2
X1
Z2

FIG. 9

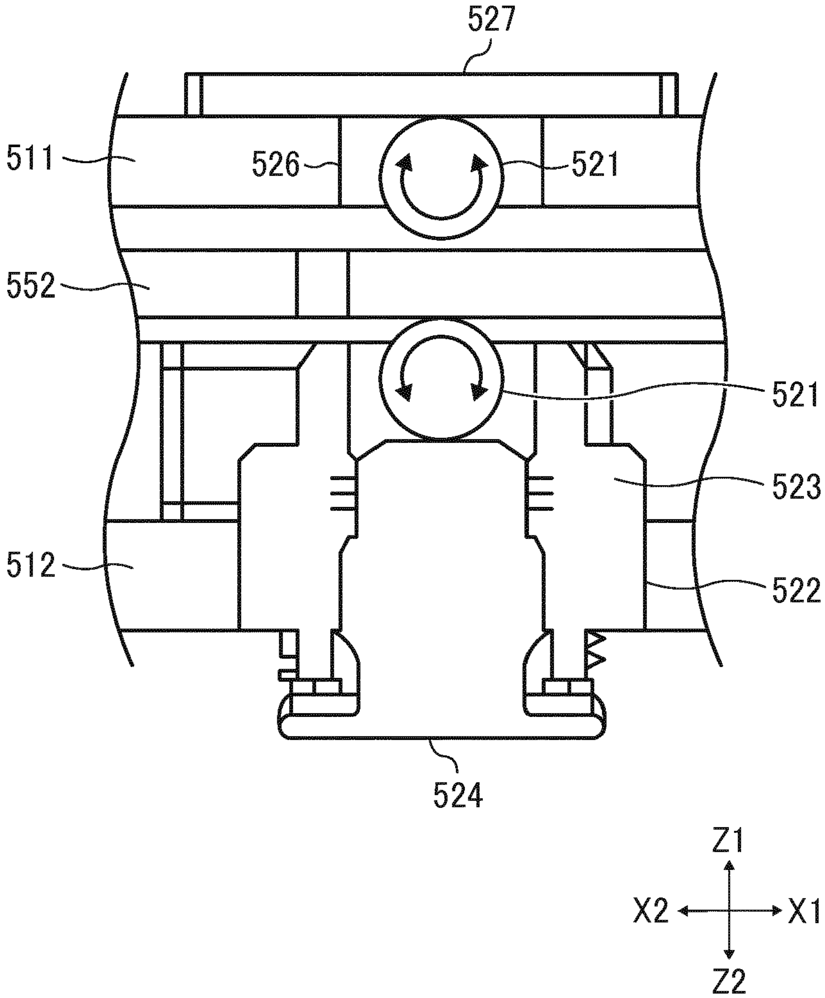

# FIG. 10

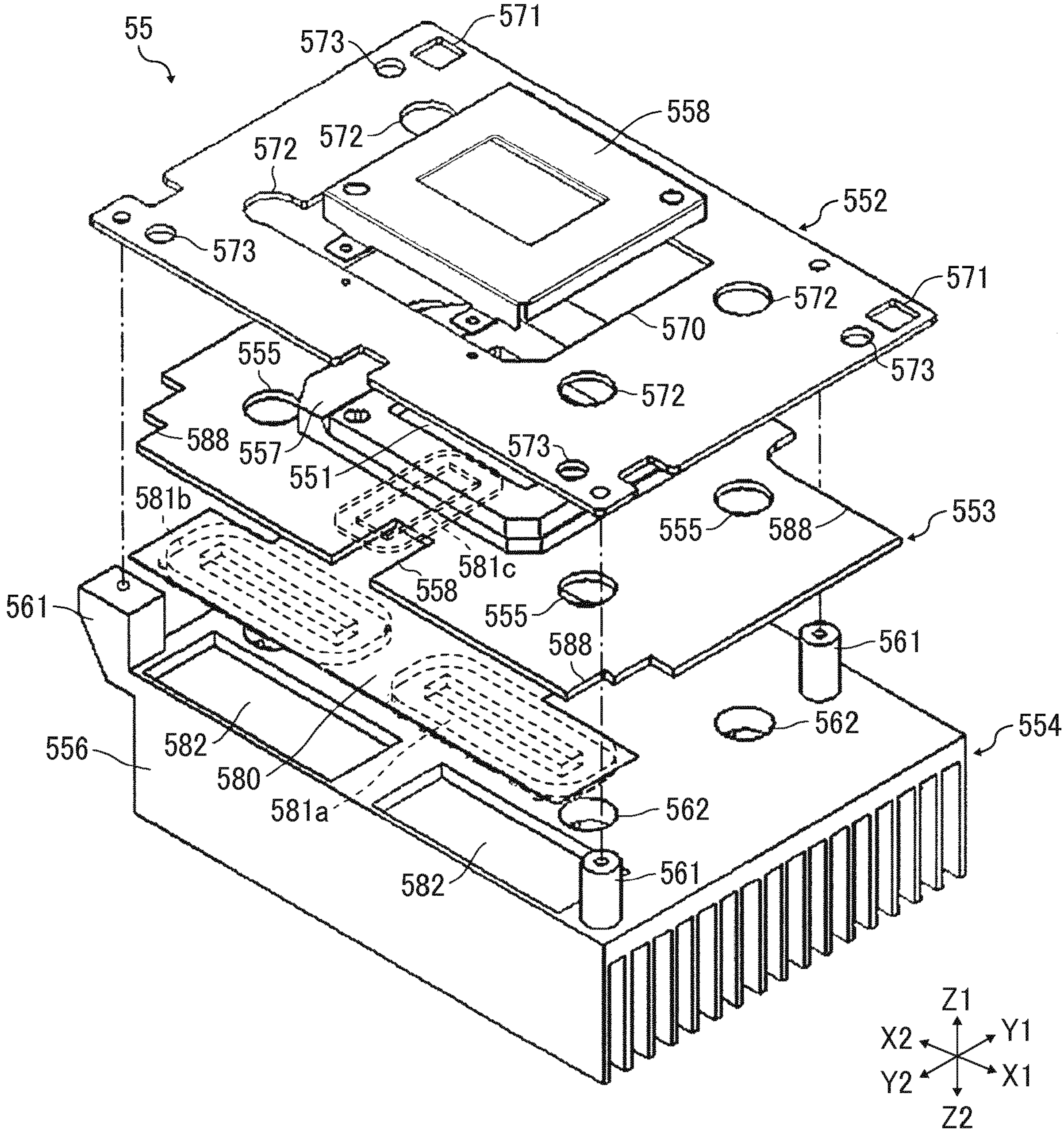
55
571
573
558
572
572
552
573
571
572
570
573
555
572
588
557
573
551
581b
555
588
553
581c
558
561
555
561
588
562
554
556
582
580
581a
562
561
582
Z1
X2
Y1
Y2
X1
Z2

# FIG. 11

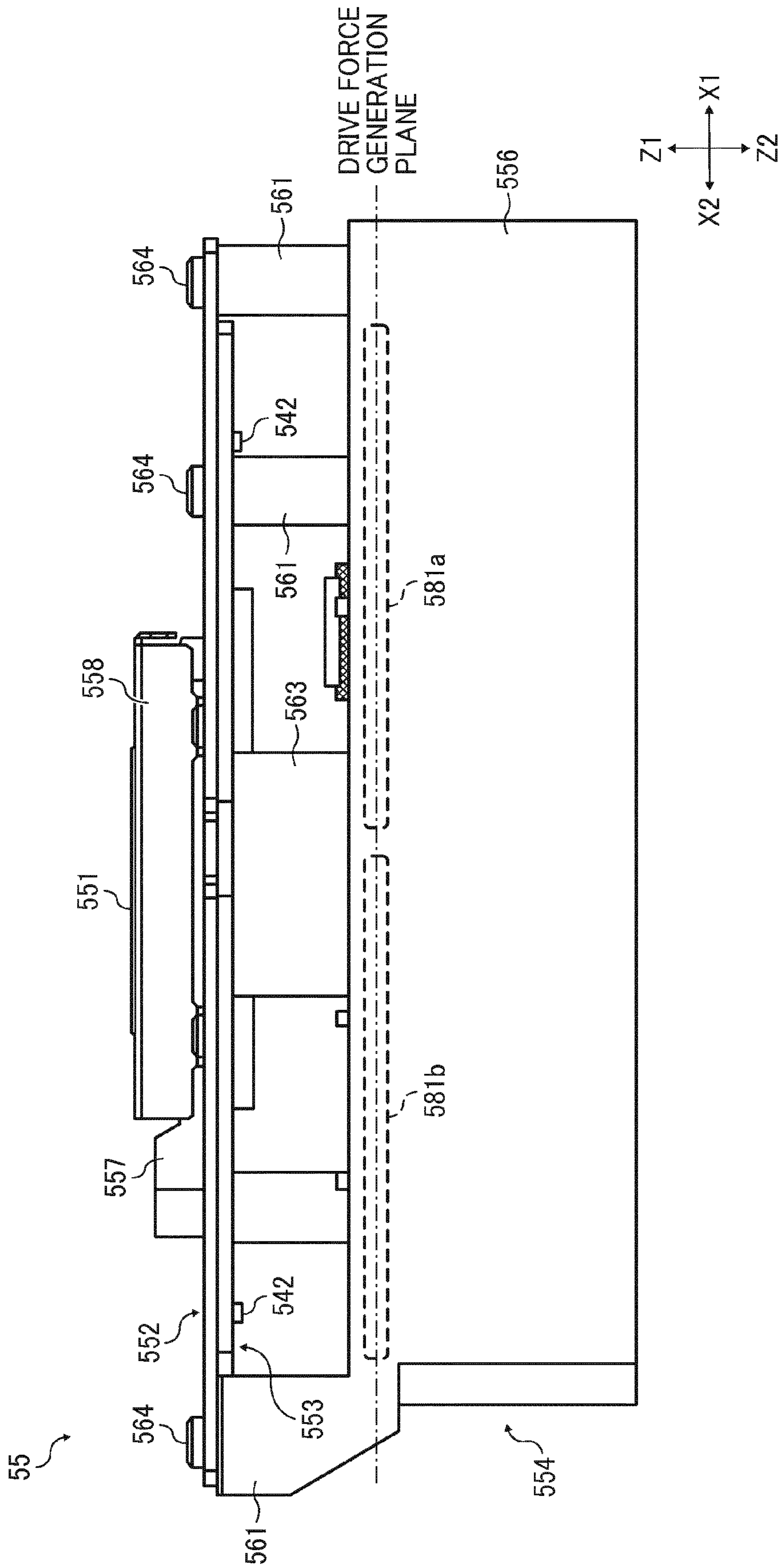

DRIVE FORCE GENERATION PLANE
X1
X2
Z1
Z2
556
561
564
542
564
561
581a
558
563
551
581b
557
542
552
553
564
55
554
561

FIG. 12

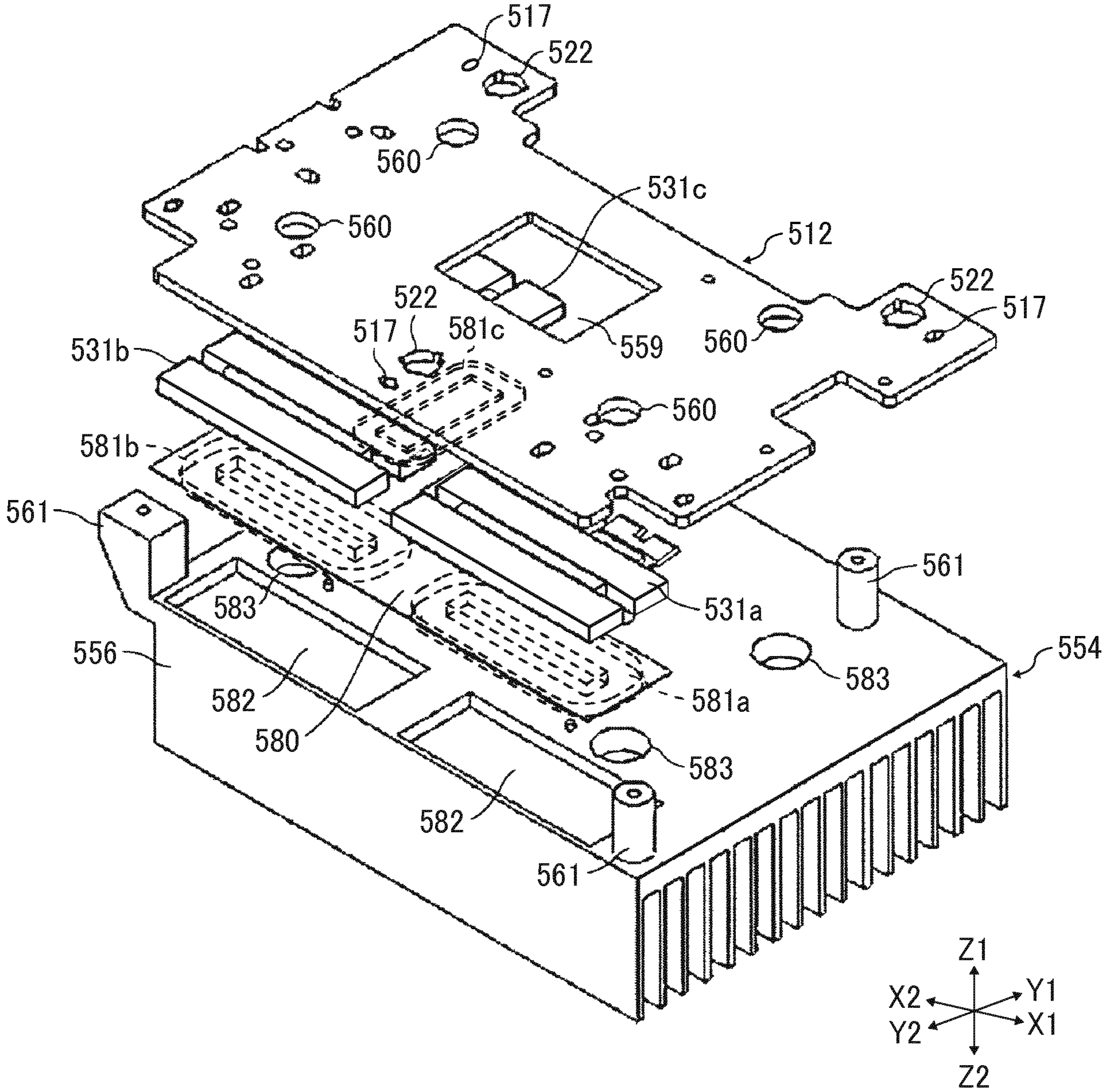
517
522
560
531c
560
512
522
517
531b
517
522
581c
559
560
560
581b
561
561
531a
583
554
556
583
582
581a
580
583
582
561
Z1
X2
Y1
Y2
X1
Z2

FIG. 13

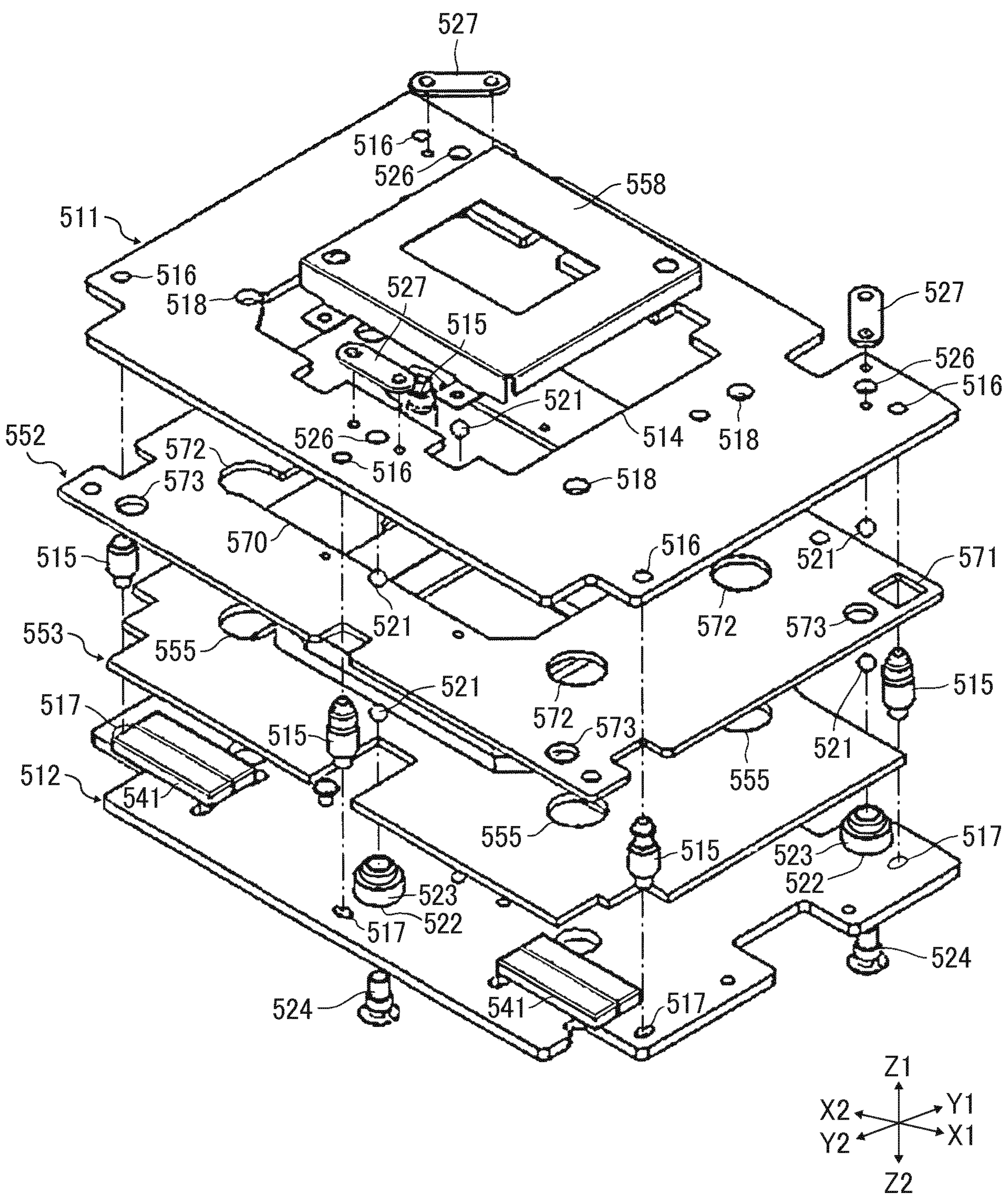
527
516
526
558
511
516
518
527
515
527
526
516
521
514
518
552
572
526
516
573
516
518
570
515
516
521
571
521
572
573
553
555
521
515
572
573
521
517
515
555
512
541
555
515
517
523
522
523
522
517
524
524
541
517
Z1
X2
Y1
Y2
X1
Z2

FIG. 14

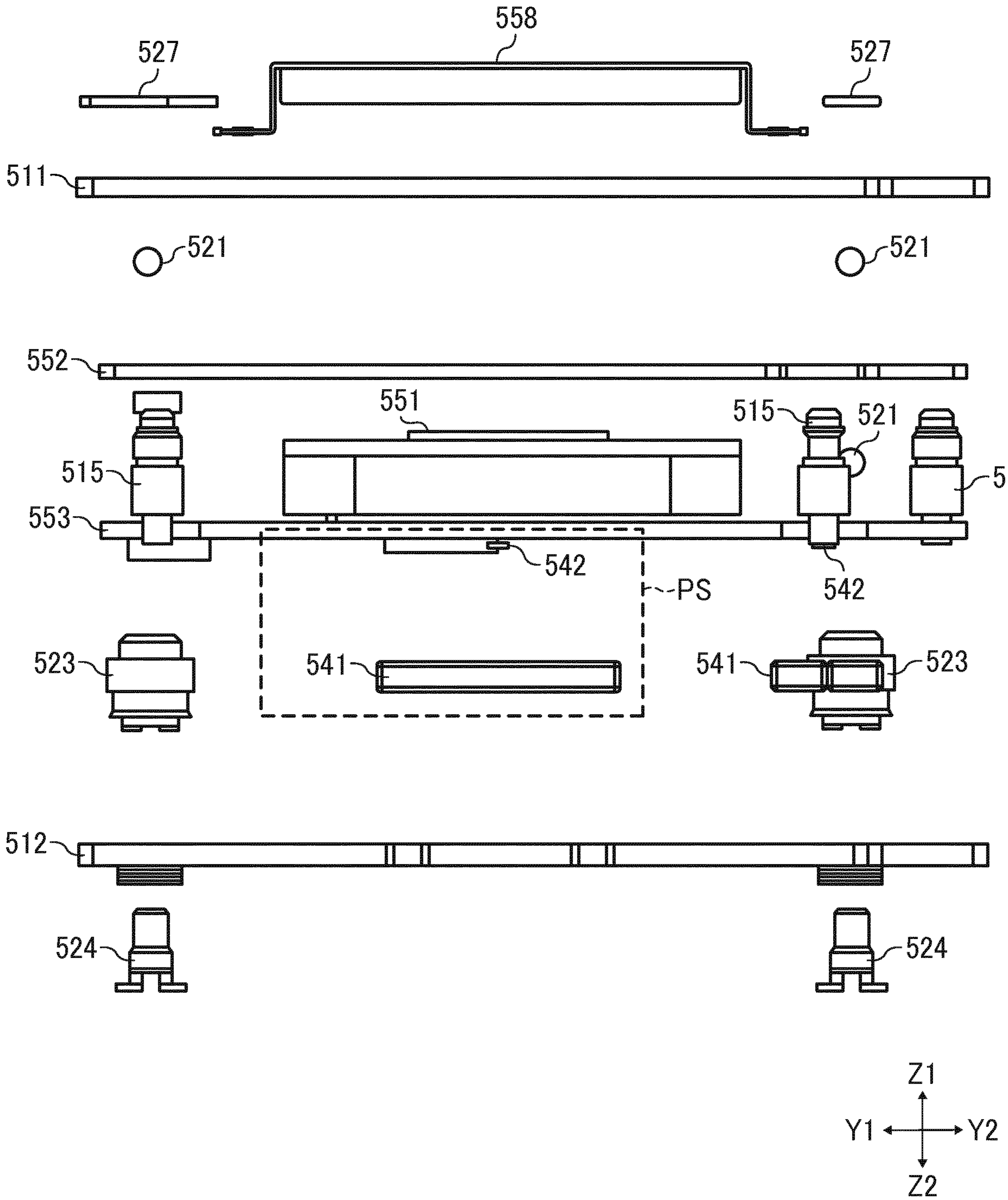
558
527
527
511
521
521
552
551
515
521
515
515
553
542
PS
542
523
541
541
523
512
524
524
Z1
Y1
Y2
Z2

FIG. 15

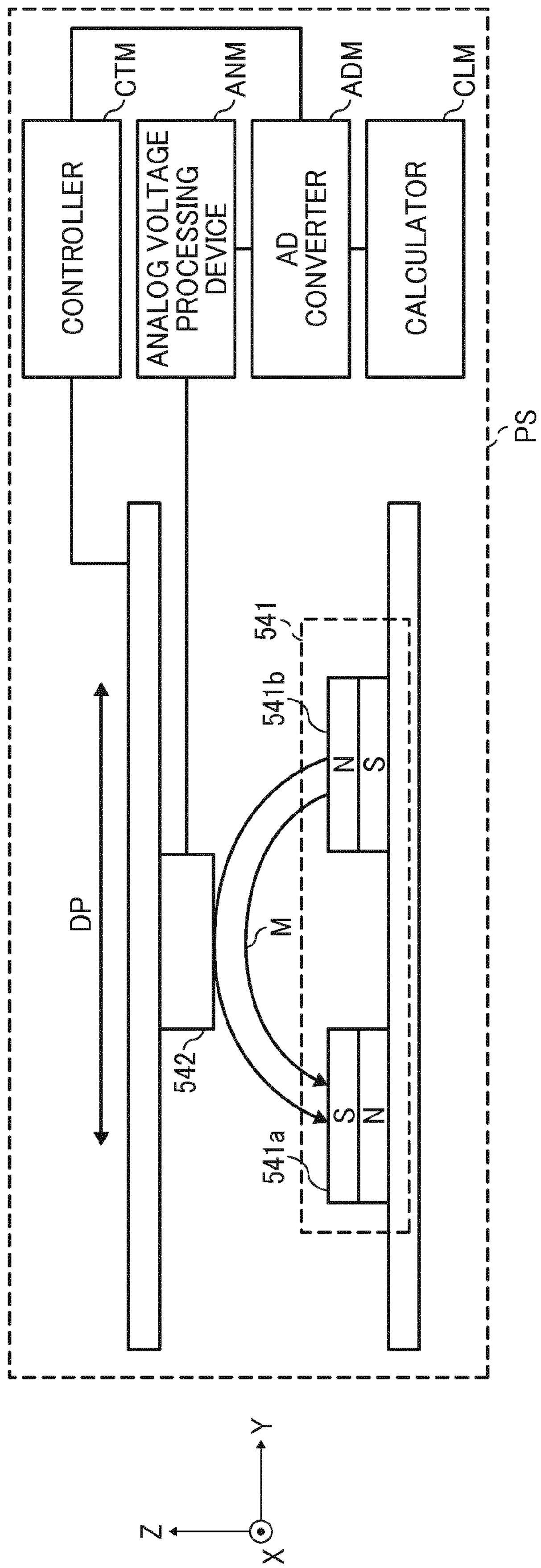
CONTROLLER
CTM
ANALOG VOLTAGE PROCESSING DEVICE
ANM
AD CONVERTER
ADM
CALCULATOR
CLM
PS
DP
542
M
541
541a
541b
S
N
N
S
Z
Y
X

FIG. 16

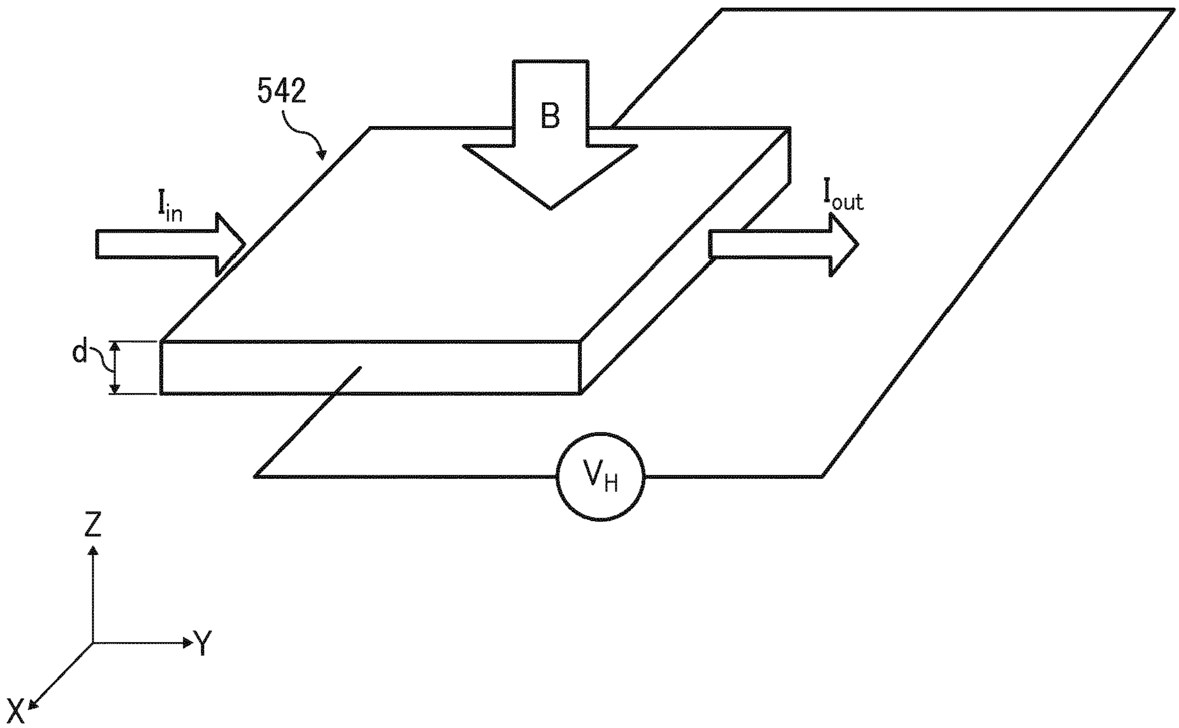

FIG. 17

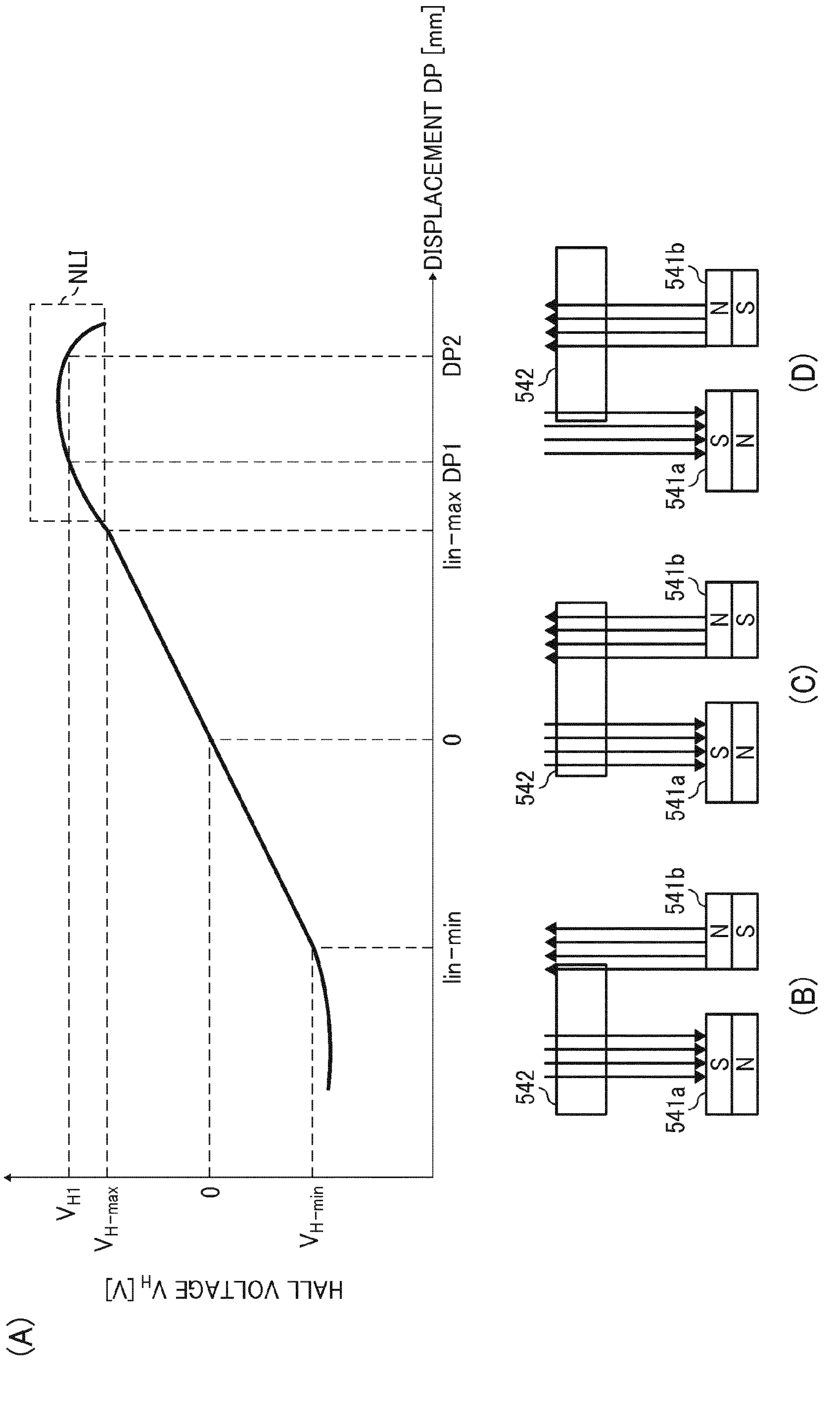
(A)
HALL VOLTAGE $V_H$ [V]
$V_{H1}$
$V_{H-max}$
0
$V_{H-min}$
NLI
DISPLACEMENT DP [mm]
lin-min
0
lin-max
DP1
DP2
542
541a
541b
S
N
(B)
(C)
(D)

FIG. 18

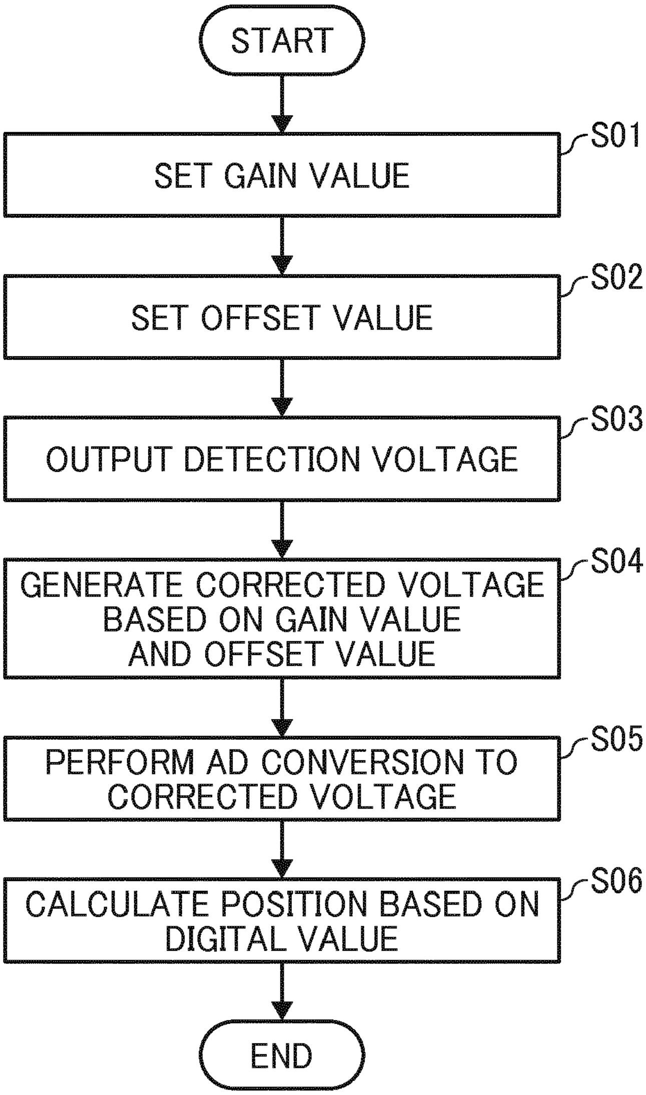
START
SET GAIN VALUE
S01
SET OFFSET VALUE
S02
OUTPUT DETECTION VOLTAGE
S03
GENERATE CORRECTED VOLTAGE BASED ON GAIN VALUE AND OFFSET VALUE
S04
PERFORM AD CONVERSION TO CORRECTED VOLTAGE
S05
CALCULATE POSITION BASED ON DIGITAL VALUE
S06
END

FIG. 19

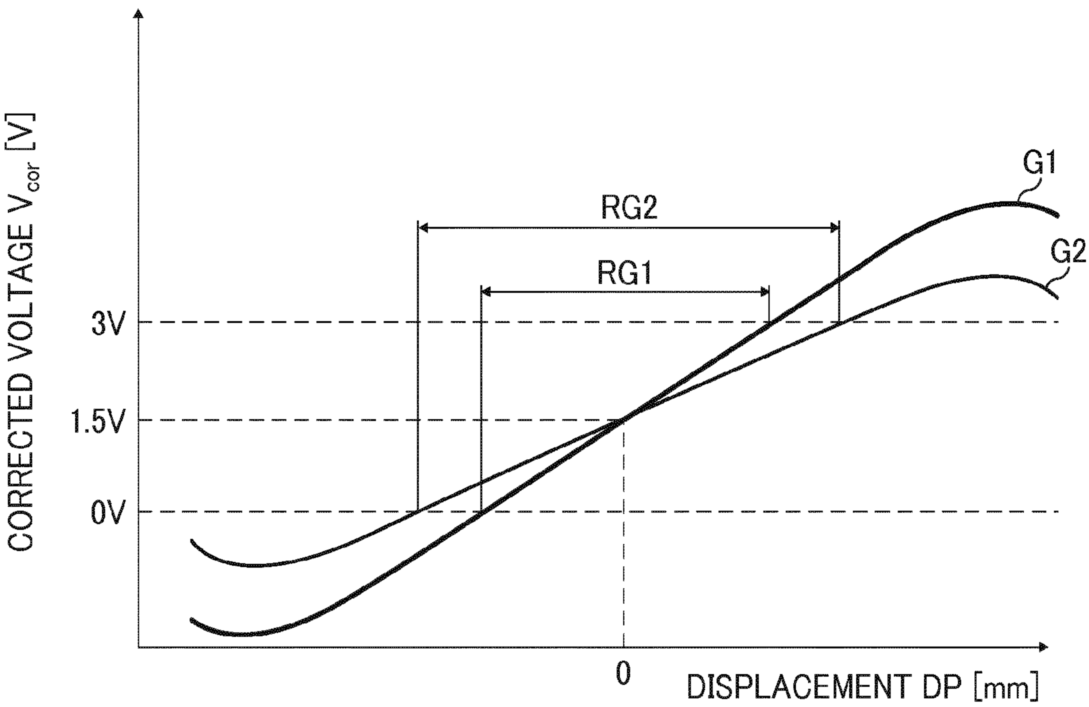
CORRECTED VOLTAGE $V_{cor}$ [V]
RG2
RG1
G1
G2
3V
1.5V
0V
0
DISPLACEMENT DP [mm]

FIG. 20

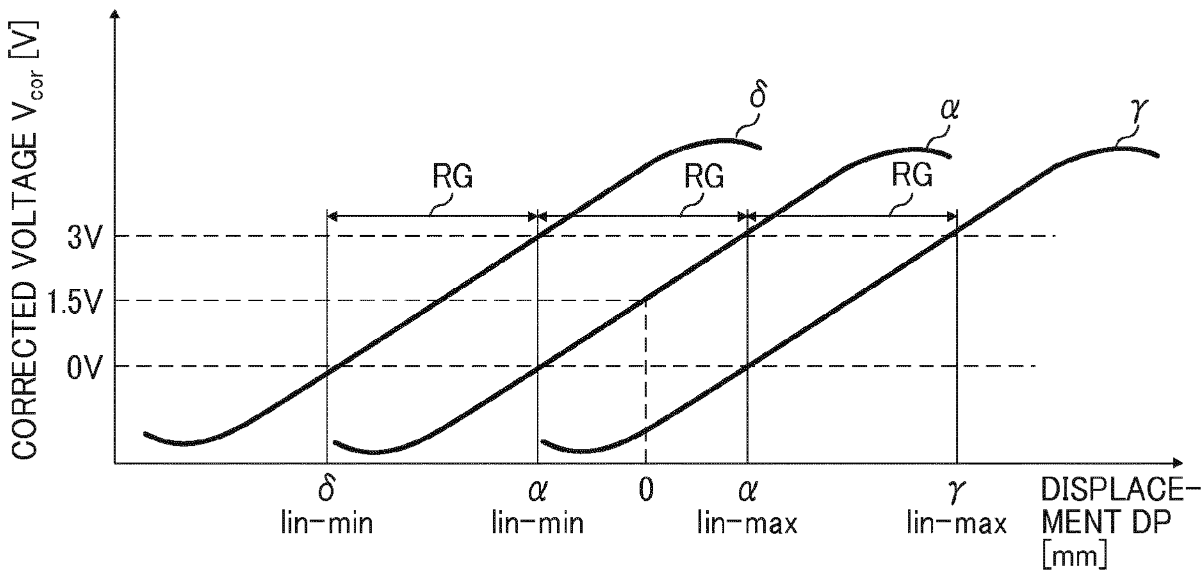
CORRECTED VOLTAGE $V_{cor}$ [V]
δ
α
γ
RG
RG
RG
3V
1.5V
0V
δ lin-min
α lin-min
0
α lin-max
γ lin-max
DISPLACE-MENT DP [mm]

FIG. 21

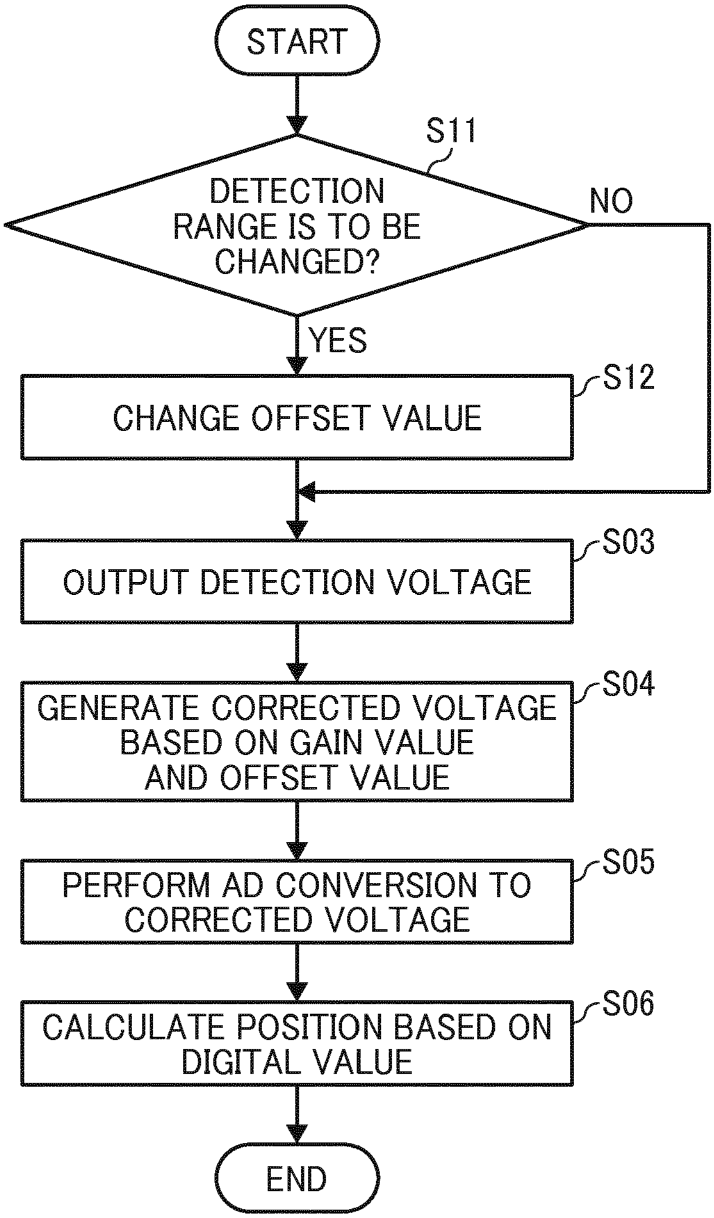
START
DETECTION RANGE IS TO BE CHANGED?
S11
NO
YES
CHANGE OFFSET VALUE
S12
OUTPUT DETECTION VOLTAGE
S03
GENERATE CORRECTED VOLTAGE BASED ON GAIN VALUE AND OFFSET VALUE
S04
PERFORM AD CONVERSION TO CORRECTED VOLTAGE
S05
CALCULATE POSITION BASED ON DIGITAL VALUE
S06
END

FIG. 22

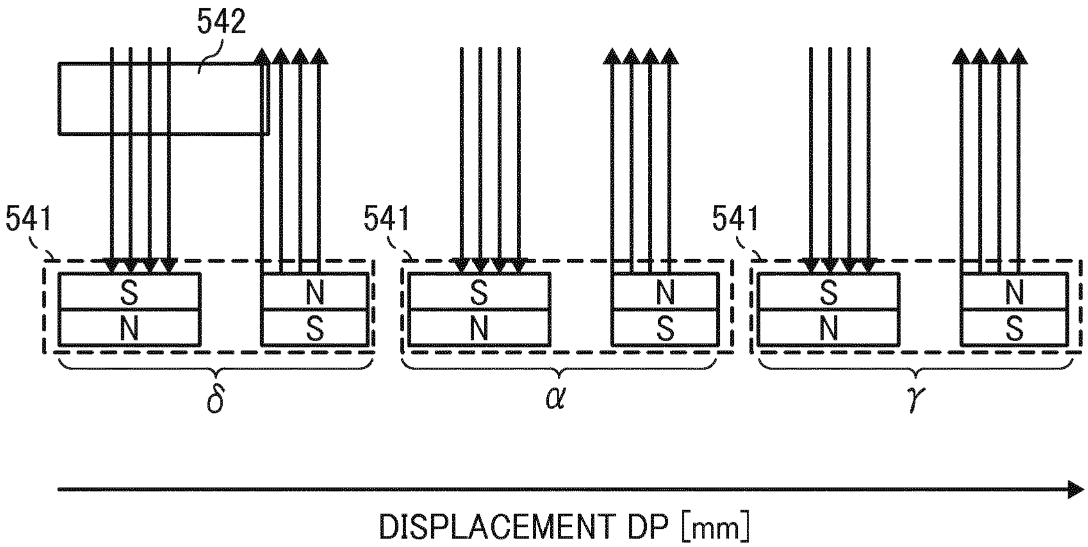

# FIG. 23

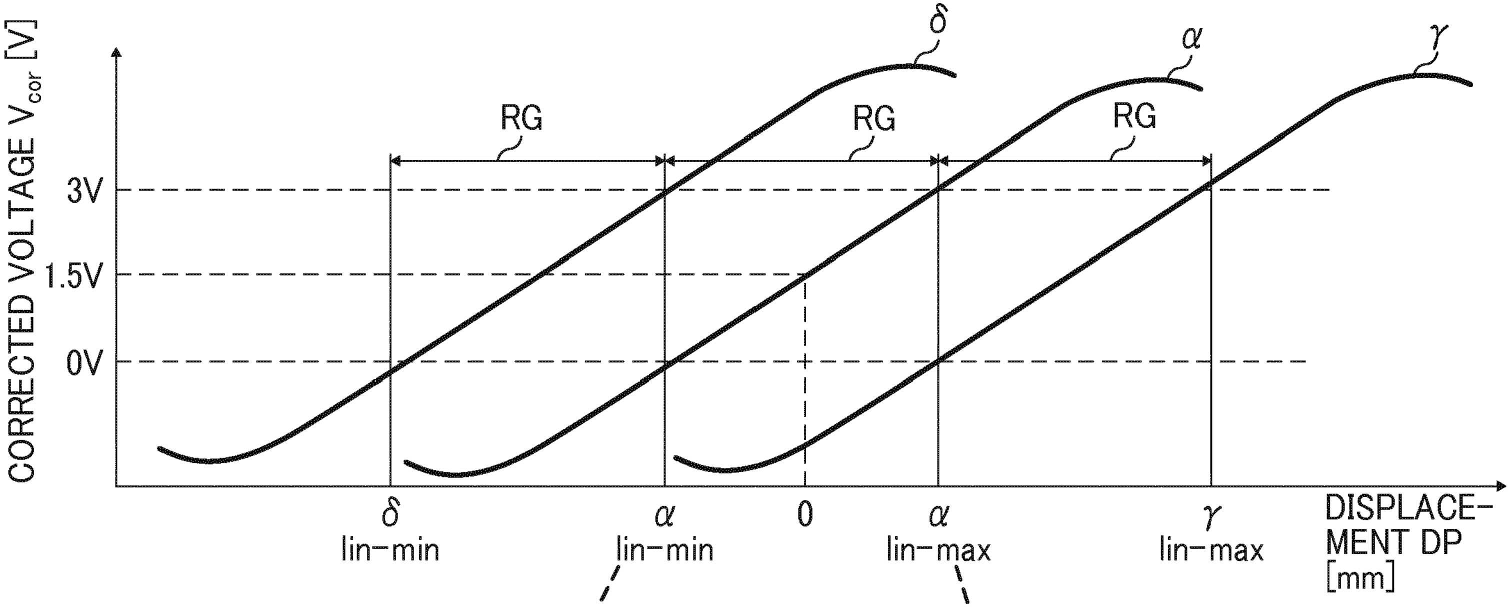


| δ TABLE | |
|---|---|
| DIGITAL VALUE | DISPLACEMENT DP |
| 0 | δ lin−min |
| 1 | δ lin−min+50[μm] |
| 2 | δ lin−min+100[μm] |
| ⋮ | ⋮ |
| 4093 | α lin−min−100[μm] |
| 4094 | α lin−min−50[μm] |
| 4095 | α lin−min |

| α TABLE | |
|---|---|
| DIGITAL VALUE | DISPLACEMENT DP |
| 0 | α lin−min |
| 1 | α lin−min+50[μm] |
| 2 | α lin−min+100[μm] |
| ⋮ | ⋮ |
| 4093 | α lin−max−100[μm] |
| 4094 | α lin−max−50[μm] |
| 4095 | α lin−max |

| γ TABLE | |
|---|---|
| DIGITAL VALUE | DISPLACEMENT DP |
| 0 | α lin−max |
| 1 | γ lin−max+50[μm] |
| 2 | γ lin−max+100[μm] |
| ⋮ | ⋮ |
| 4093 | γ lin−max−100[μm] |
| 4094 | γ lin−max−50[μm] |
| 4095 | γ lin−max |

FIG. 24

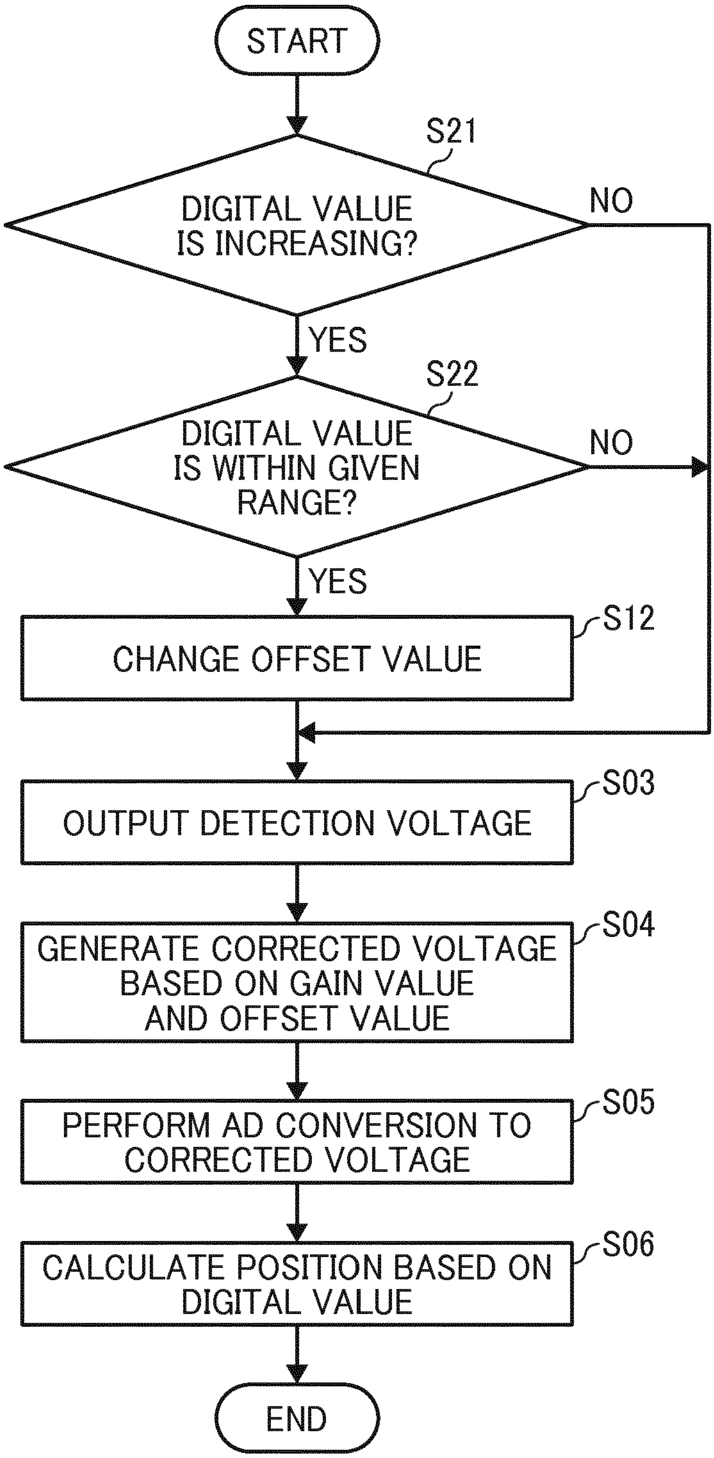
START
S21
DIGITAL VALUE IS INCREASING?
NO
YES
S22
DIGITAL VALUE IS WITHIN GIVEN RANGE?
NO
YES
S12
CHANGE OFFSET VALUE
S03
OUTPUT DETECTION VOLTAGE
S04
GENERATE CORRECTED VOLTAGE BASED ON GAIN VALUE AND OFFSET VALUE
S05
PERFORM AD CONVERSION TO CORRECTED VOLTAGE
S06
CALCULATE POSITION BASED ON DIGITAL VALUE
END

FIG. 25A

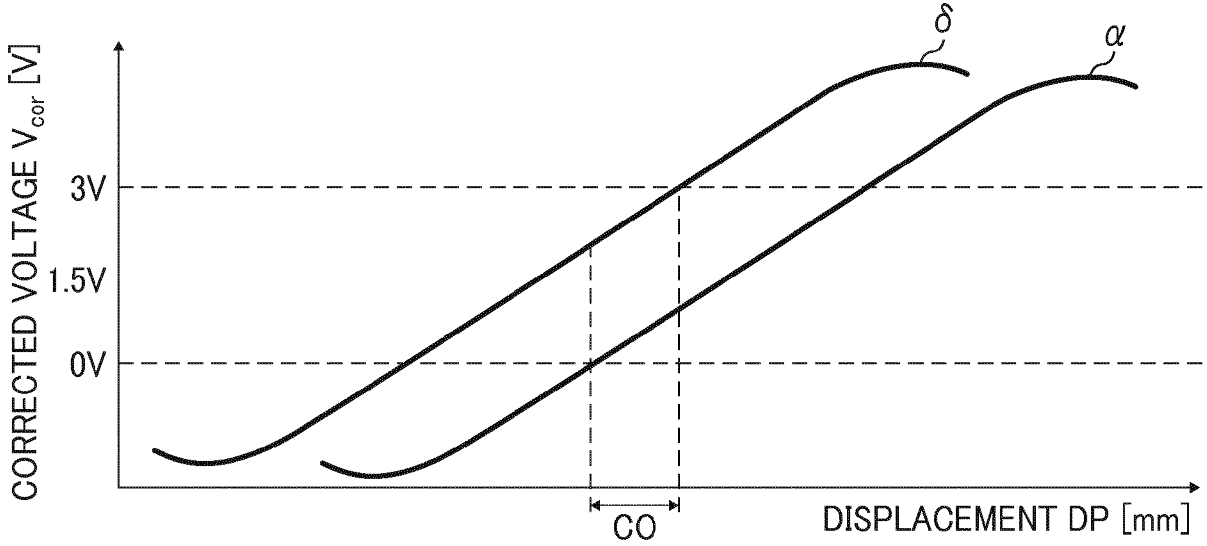


| δ TABLE | |
|---|---|
| DIGITAL VALUE | DISPLACEMENT DP |
| 0 | −6140 [μm] |
| 1 | −6139 [μm] |
| 2 | −6138 [μm] |
| 3 | −6137 [μm] |
| 4 | −6136 [μm] |
| ⋮ | ⋮ |
| 4091 | −2049 [μm] |
| 4092 | −2048 [μm] |
| 4093 | −2047 [μm] |
| 4094 | −2046 [μm] |
| 4095 | −2045 [μm] |



| α TABLE | |
|---|---|
| DIGITAL VALUE | DISPLACEMENT DP |
| 0 | −2048 [μm] |
| 1 | −2047 [μm] |
| 2 | −2046 [μm] |
| 3 | −2045 [μm] |
| 4 | −2044 [μm] |
| ⋮ | ⋮ |
| 4091 | 2044 [μm] |
| 4092 | 2045 [μm] |
| 4093 | 2046 [μm] |
| 4094 | 2047 [μm] |
| 4095 | 2048 [μm] |

# FIG. 25B

CO

| α TABLE | |
|---|---|
| DIGITAL VALUE | DISPLACEMENT DP |
| 0 | −2048 [μm] |
| 1 | −2047 [μm] |
| 2 | −2046 [μm] |
| 3 | −2045 [μm] |
| 4 | −2044 [μm] |
| ⋮ | ⋮ |
| 4091 | 2044 [μm] |
| 4092 | 2045 [μm] |
| 4093 | 2046 [μm] |
| 4094 | 2047 [μm] |
| 4095 | 2048 [μm] |

CO

| α TABLE | |
|---|---|
| DIGITAL VALUE | DISPLACEMENT DP |
| 0 | −2049 [μm] |
| 1 | −2048 [μm] |
| 2 | −2047 [μm] |
| 3 | −2046 [μm] |
| 4 | −2045 [μm] |
| ⋮ | ⋮ |
| 4091 | 2043 [μm] |
| 4092 | 2044 [μm] |
| 4093 | 2045 [μm] |
| 4094 | 2046 [μm] |
| 4095 | 2047 [μm] |

CO

| α TABLE | |
|---|---|
| DIGITAL VALUE | DISPLACEMENT DP |
| 0 | −2049 [μm] |
| 1 | −2048 [μm] |
| 2 | −2047 [μm] |
| 3 | −2046 [μm] |
| 4 | −2045 [μm] |
| ⋮ | ⋮ |
| 4091 | 2043 [μm] |
| 4092 | 2044 [μm] |
| 4093 | 2045 [μm] |
| 4094 | 2046 [μm] |
| 4095 | 2047 [μm] |

FIG. 26

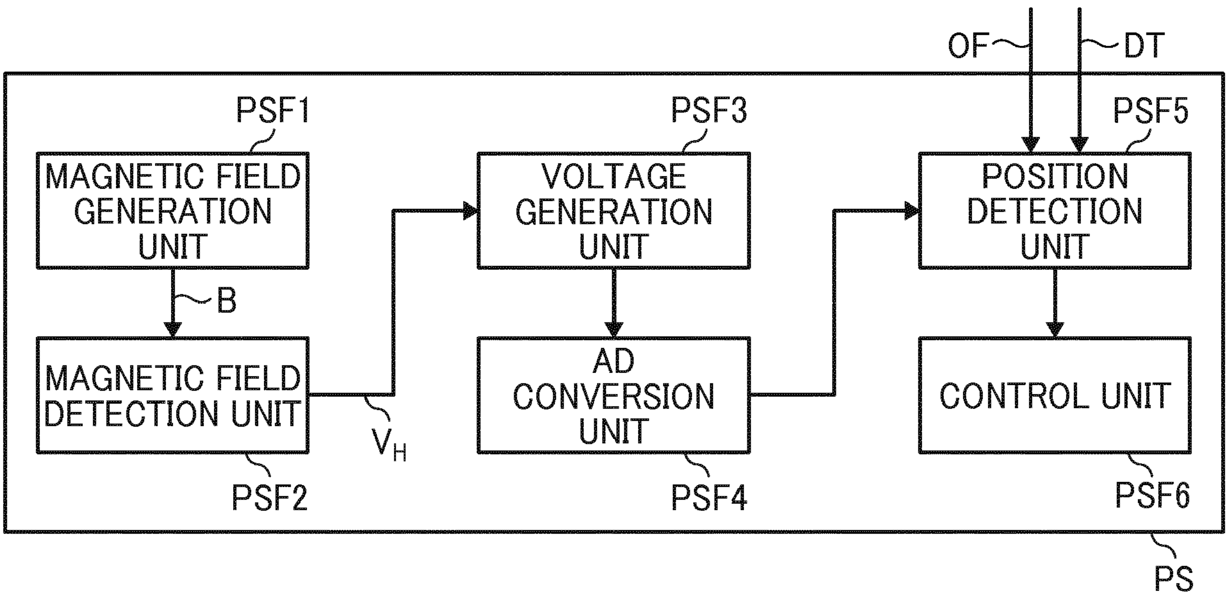
OF
DT
PSF1
MAGNETIC FIELD GENERATION UNIT
B
MAGNETIC FIELD DETECTION UNIT
PSF2
$V_H$
PSF3
VOLTAGE GENERATION UNIT
AD CONVERSION UNIT
PSF4
PSF5
POSITION DETECTION UNIT
CONTROL UNIT
PSF6
PS

Europäisches Patentamt
European Patent Office
Office européen des brevets

# EUROPEAN SEARCH REPORT

Application Number
EP 17 17 9368

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2009/060716 A1 (KONICA MINOLTA OPTO INC [JP]; YANO SO [JP]; MAEDA HIDEO [JP]) 14 May 2009 (2009-05-14) * the whole document * ----- | 1-10 | INV. G01R33/00 G01D5/14 |
| A | JP 3 361567 B2 (PHILIPS ELECTRONICS NV) 7 January 2003 (2003-01-07) * paragraph [0022]; figure 10 * ----- | 1-10 | |
| A | US 2008/048652 A1 (MURAKITA MASASHI [JP]) 28 February 2008 (2008-02-28) * the whole document * ----- | 1-10 | |

TECHNICAL FIELDS SEARCHED (IPC)

G01D
G01R

The present search report has been drawn up for all claims

1

| Place of search | Date of completion of the search | Examiner |
|---|---|---|
| Munich | 12 December 2017 | Jedlicska, István |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

# ANNEX TO THE EUROPEAN SEARCH REPORT ON EUROPEAN PATENT APPLICATION NO. EP 17 17 9368

This annex lists the patent family members relating to the patent documents cited in the above-mentioned European search report. The members are as contained in the European Patent Office EDP file on
The European Patent Office is in no way liable for these particulars which are merely given for the purpose of information.

12-12-2017

| Patent document cited in search report | Publication date | Patent family member(s) | Publication date |
|---|---|---|---|
| WO 2009060716 A1 | 14-05-2009 | JP 5218418 B2 | 26-06-2013 |
| | | JP WO2009060716 A1 | 24-03-2011 |
| | | WO 2009060716 A1 | 14-05-2009 |
| JP 3361567 B2 | 07-01-2003 | DE 69310820 D1 | 26-06-1997 |
| | | DE 69310820 T2 | 20-11-1997 |
| | | EP 0578299 A1 | 12-01-1994 |
| | | JP 3361567 B2 | 07-01-2003 |
| | | JP H0666508 A | 08-03-1994 |
| | | US 5300883 A | 05-04-1994 |
| US 2008048652 A1 | 28-02-2008 | JP 4495699 B2 | 07-07-2010 |
| | | JP 2008020704 A | 31-01-2008 |
| | | US 2008048652 A1 | 28-02-2008 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2006292396 A